(19) Europäisches Patentamt
European Patent Office
Office européen des brevets

(11) EP 1 296 458 B1

(12) EUROPEAN PATENT SPECIFICATION

(45) Date of publication and mention of the grant of the patent:
**08.12.2004 Bulletin 2004/50**

(51) Int Cl.[7]: **H04B 1/30**

(21) Application number: **01122741.0**

(22) Date of filing: **21.09.2001**

(54) **Five-port receiver with passive isolation**

Fünf-Tor Empfänger mit passiven Isolation

Récepteur à cinq portes avec isolation passif

(84) Designated Contracting States:
**DE FR GB**

(43) Date of publication of application:
**26.03.2003 Bulletin 2003/13**

(73) Proprietors:
- **Sony International (Europe) GmbH**
  **10785 Berlin (DE)**
- **Sony Corporation**
  **Tokyo 141-0001 (JP)**

(72) Inventors:
- **Brankovic, Veselin,**
  **c/oAdv. Techn. Cente.Stuttgart**
  **70327 Stuttgart (DE)**
- **Krupezevic, Dragan,**
  **c/oAdv. Techn. Cente.Stuttgart**
  **70327 Stuttgart (DE)**
- **Ratni, Mohamed,**
  **c/oAdvanc. Techn. Center Stuttgart**
  **70327 Stuttgart (DE)**
- **Abe, Masayoshi**
  **Shinagawa-ku, Tokyo 141-0001 (JP)**
- **Sasho, Noboru**
  **Shinagawa-ku, Tokyo 141-0001 (JP)**

(74) Representative: **Rupp, Christian, Dipl.Phys. et al**
**Mitscherlich & Partner**
**Patent- und Rechtsanwälte**
**Sonnenstrasse 33**
**80331 München (DE)**

(56) References cited:
**EP-A- 0 957 614**
**EP-A- 1 067 675**
**US-A- 4 427 936**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 296 458 B1

## Description

FIELD AND BACKGROUND OF THE INVENTION

The present invention generally relates to the field of five-port receivers, especially to a five-port junction device for the processing of modulated RF signals, a mobile receiver comprising a five-port junction device and to a method for processing said RF signals.

N-port network technology can successfully be used for a direct downconversion of RF modulated signals. One of the network topologies being well-known to the art is five-port topology using three power sensors.

BRIEF DESCRIPTION OF THE PRESENT STATE OF THE ART

According to the state of the art, there are different methods to the problem of RF downconversion, each of them being optimized to a specific application environment, and thus implying certain restrictions. In order to explain these solutions, it is necessary to briefly describe some of their characterizing features.

Six-port receivers as disclosed in the European patent application EP-A-0 896 455 are known for enabling a direct down-conversion of received modulated RF signals from millimeter wave and microwave range to the baseband. Thereby, the six-port receiver detects the phase difference and the amplitude ratio of two incoming RF signals by using the information of superimposed, mutually interfering RF signals. To perform the downconversion of the modulated RF signals, a classical I/Q demodulator is not needed. With the aid of suitable calibration procedures the influence of non-ideal linear RF components (including manufacturing tolerances of these components) can be minimized. The circuitry of six-port receivers can be realized by only employing passive components in combination with power sensors for the detection of the phase difference and the amplitude ratio of said RF signals. An important feature of six-port receivers is that fabrication tolerances of the employed RF components can be calibrated, which inherently allows the usage of low-cost RF components.

A structure for a six-port receiver is proposed in the IEEE MTT Symposium report "A Six-Port Direct Digital Millimeter Wave Receiver" (vol. 3, pp. 1659 to 1662, San Diego, May 1994) of Ji Li, R. G. Bossisio and Ke Wu. Therein, a novel scheme for a digital phase demodulation of modulated millimeter and microwave waves by means of a six-port receiver is presented. Due to said scheme some disadvantages of conventional receivers, wherein I/Q demodulators are used for a direct downconversion of the received RF signals, are overcome.

Six-port technique is known to accurately measure both amplitude and phase of the scattering parameters in a microwave network. Instead of using heterodyne receivers, a six-port receiver accomplishes direct measurements at millimeter and microwave frequencies to perform a direct demodulation of received RF signals by extracting power levels at four of the six ports. The imperfections of the hardware such as phase errors of the bridges, imbalance of the power detectors, etc. can readily be eliminated by means of an appropriate calibration procedure. This significantly reduces the requirements of an hardware implementation and enables the six-port receiver to be operated within a wide band up to millimeter wave frequencies. Thereby, very accurate measurements can be made over a large dynamic range and a wide frequency range. Six-port junction receivers consist of passive microwave components such as directional couplers and power dividers as well as diode detectors. The underlying circuit can easily be integrated as a Monolithic Microwave Integrated Circuit (MMIC).

From the European patent application EP 0 957 573 A1 a five-port junction device is disclosed which can be used for processing received RF signals in order to perform a direct down-conversion of said RF signals. The device comprises a passive four-port network being connected with a passive three-port network by means of a phase shifter. Thereby, one port of said passive four-port network acts as an input port used for the input of a first RF signal, and two ports of said passive four-port network act as output ports. The passive three-port comprises one port used for the input of a second RF signal and one output port. In the disclosed topology a passive isolation is provided as depicted in Figs. 2a+b. In this case at least two phase shifters are applied along with four passive structures, which provide a signal splitting and combine functional features. The output ports respectively provide output signals which can be obtained as linear combinations of the first and the second RF signal. Three power sensors, each connected to one of said three output ports and a digital signal processor (DSP), serve to detect the respective power levels of the obtained output signals. The DSP is provided to calculate the complex ratio of the first and the second RF signal on the basis of the three power levels $P_1$, $P_2$ and $P_3$ detected by the power sensors.

In the following the functions of the structures depicted in Figs. 2a-c and 3, which is disclosed in the European patent application EP 0 957 573 A1, is explained.

Fig. 2a shows a solution according to the state of the art. It comprises one passive four-port network 114 and one passive three-port network 110 connected with each other by a non-reciprocal active circuitry 112 which acts as a passive isolation between the RF signal ($S_1$) and the LO signal ($S_2$). Thereby, $S_1$ and $S_2$ are the input signals of the passive three-port network 110 and the passive four-port network 114, respectively.

The passive three-port network 110 comprises one port for the input of the RF signal ($S_1$), one port for the connection with the non-reciprocal active circuitry 112 and one port for the output of one signal representing the power level $P_3$ to the power sensor 106a. By contrast, the passive four-port network 114 comprises one port for the input of the LO signal ($S_2$), one port for the connection with the non-reciprocal active circuitry 112 and two ports for the output of two signals representing the power levels $P_4$ and $P_5$ to the power sensors 106b and 106c, respectively. When the disclosed topology is used as a receiver, the power sensors 106a-c are matched, for example on an impedance of 50 Ω.

The output signals of the passive four-port network 114 and the passive three-port network 110 represent linear combinations and eventually phase shifts of the input RF signals ($S_1$ and $S_2$), as known from the technical field of six-port receivers. The power sensors 106a-c detect the power levels ($P_3$, $P_4$ and $P_5$) of the output signals at the output ports 102b, 102c and 102d of the passive five-port network 102, which are then supplied to a digital signal processor unit 101b. Usually, a plurality of circuit elements such as lowpass filters, DC amplifiers and analog-to-digital converters are connected between each of said power sensors 106a-c and the digital signal processor 101b, which are not shown in the drawings.

The digital signal processor 101b calculates the complex ratio (S) of the RF signal ($S_1$) and the LO signal ($S_2$) by means of the detected power levels ($P_3$, $P_4$ and $P_5$) at the ports 102b-d of the disclosed five-port network 102 in order to provide a demodulation of the received RF signal ($S_1$).

Fig. 2b shows a detailed view of the components included in the passive four-port network 114 according to the state of the art. These components comprise a passive power divider 114 and a passive three-port network 114b connected to each other and with the output ports of said passive four-port network 114.

In Fig. 2c a topology is depicted providing an isolation between the RF signal ($S_1$) and the LO signal ($S_2$) by means of a four-port structure according to the state of the art using passive circuit elements such as passive power dividers 302a+b, passive three-port networks 110 and 114b and phase shifters 112a-c.

Fig. 3 shows a topology providing an isolation between the RF signal ($S_1$) and the LO signal ($S_2$) by means of a five-port network according to the state of the art using passive circuit elements such as passive power dividers 114a and 302a+b, passive three-port networks 110 and 114b and phase shifters 112a-c.

EP 0 957 614 A1 generally relates to an *N*-port demodulator of a wireless RF receiver and a corresponding method for I/Q-demodulating PSK- or QAM-modulated RF signals. The I/Q demodulator thereby comprises a passive *N*-port junction device (e.g. a six-port or five-port junction device), wherein a plurality of power detectors are provided which are supplied with analog output signals of the five-port or six-port junction device. An analog circuitry is supplied with the output signals of the power detectors. The analog circuitry detects the I/Q components of the signal to be demodulated based on an analog processing of the analog output signals of the power detectors. A local oscillator circuitry is provided to supply a second input signal for the five-port or six-port junction device. Moreover, filters are provided for filtering the analog output signals of the power detectors before they are supplied to the analog circuitry. The analog circuitry comprises circuits to supply the analog output signals of the power detectors respectively in two branches. Furthermore, amplifiers with individually adjustable gains are provided for each branch. Finally, an adding/subtracting circuitry is provided which is supplied with the individually amplified branches to detect the I/Q components of the RF signal to be demodulated. According to the herein described invention, said five-port or six-port junction device is calibrated by a processing unit which adjusts at least one of the adjustable gains.

The PCT patent application PCT/EP98/08329 refers to a N-port junction device (with $N \geq 4$) used in the receiver of a mobile telecommunications device for processing modulated RF signals comprising two RF input ports, two passive signal combining units connected to each other by means of a phase shifting element, wherein the first one of said passive signal combining units is fed with a first RF input signal and the second one of said passive signal combining units is fed with a second RF input signal. Additionally, said N-port junction device comprises at least two power sensors, each connected to one of the output ports of said passive signal combining units.

One of the important issues in the five-port network design is the isolation between the local oscillator (LO) and radio frequency (RF) input signals. The corresponding solution according to the state of the art is proposed in the European patent application EP 1 061 660 A1, wherein the isolation is provided by an active device. Therein, a N-port RF receiver (with $N \geq 3$) for modulated RF signals is proposed, which is based on a N-port junction providing an isolation between the RF signal and the LO signal. In the preferred embodiment of said invention the disclosed N-port junction is supplied with a first RF signal at a first input port (RF port) and with a second RF signal originating from a local oscillator (LO) at a second input port (LO port). Furthermore, the N-port junction contains a RF/LO isolation block comprising a non-reciprocal active circuitry for isolating the LO signal from the RF signal. Thereby, it can be ensured that the LO signal is significantly attenuated at the RF input port.

An alternative way to provide isolation by passive means is the usage of hybrid microwave printed circuits. However, this approach requires a specific implementation topology and a four-port approach, wherein usually one port is out of use and has to be terminated by an impedance of 50 Ω. In the cited approach according to the state of the art several of those hybrid microwave printed circuits are combined in order to provide the required phase shifts.

DEFICIENCIES AND DISADVANTAGES OF THE KNOWN SOLUTIONS OF THE PRESENT STATE OF THE ART

As mentioned above, each of the applied network solutions used for a demodulation of received RF signals is optimized to a specific purpose, and thus contains certain limitations.

For example, the network topology disclosed in the preferred embodiment of the European patent application EP 0 957 573 A1 only works in case of a four-port receiver structure, and also in the case when the intensity of the received signal does not play an important role, for example in case of PSK modulation.

OBJECT OF THE UNDERLYING INVENTION

In view of the explanations mentioned above it is the object of the invention to propose a low-cost and low-power approach for a receiver network topology applied to a wireless receiver system, which enables an improved isolation of the RF signal and the LO signal without complex digital signal processing or additional components such as resistive couplers and/or balance-to-unbalance transformers.

This object is achieved by means of the features of the independent claims. Advantageous features are defined in the dependent claims.

SUMMARY OF THE INVENTION

The underlying invention describes a low-complexity and low-effort solution for a five-port network topology of a mobile radio receiver used for demodulation of received modulated RF signals which can easily be realized. Thereby, the invention is specially optimized for an isolation between said received modulated RF signal and a further RF signal originating from a local oscillator (LO) used for the downconversion of said received modulated RF signal.

In the underlying invention a simple passive network topology is disclosed, which does not need any active devices for the purpose of isolation between the LO and RF input signals. Instead, it exhibits a topology comprising three phase shifters, four passive structures and several additional features which shall be described in the following sections. Said topology can easily be integrated in a Monolithic Microwave Integrated Circuit (MMIC).

In contrast to conventional solutions according to the state of the art, the advantages of the proposed circuit topology according to the preferred embodiment of the underlying invention are:

- providing a RF/LO isolation with the aid of passive means for a five-port receiver using three phase shifters for a plurality of possible realizations, wherein power-consuming active devices are not needed;

- simultaneously providing a simple RF isolation at the third port of the power detector by means of simple passive networks, wherein complicated passive couplers and balance-to-unbalance ("balun") transformers are not needed;

- using phase shifters and resistors with carefully chosen values.

With the aid of a novel method according to the underlying invention the I/Q values can be calculated by combination of only two unknowns, for example the power values $P_3$ and $P_5$ for the I values and $P_3$ and $P_4$ for the Q values, respectively. Compared with the five-port solution of the state of the art, wherein all three values are needed for the calculation of the I and Q values, respectively, the solution according to the underlying invention as depicted in Fig. 4 enables a significant reduction of the digital processing efforts. An optional resistive solution of the embodiment depicted in Fig. 4 is presented in Fig. 5.

BRIEF DESCRIPTION OF THE CLAIMS

In general, those skilled in the art will readily recognize that the realization of the underlying invention is not restricted to the above-described examples. Many modifications and variations may be made to the embodiments of the underlying invention disclosed herein without substantially departing from the scope of the invention as defined in the following claims.

The independent claim 1 and the dependent claims 2 to 12 refer to a five-port junction device used for the processing of modulated RF signals in a mobile radio receiver. Thereby, said five-port junction device comprises

- at least two RF input ports for the two RF input signals ($S_1$ and $S_2$),

- at least three output ports for output signals representing three detected power levels ($P_3$, $P_4$ and $P_5$),

- two passive N-port networks connected to each other by a non-reciprocal circuitry, wherein each of said passive N-port networks is connected to one of said RF input ports, respectively,
- at least three power detectors used for detecting the respective power levels ($P_3$, $P_4$ and $P_5$) of the output signals, and
- at least one digital signal processor used for processing the detected power levels ($P_3$, $P_4$ and $P_5$) being connected with said power detectors over an interface for direct current (DC) signals.

The non-reciprocal circuitry according to the preferred embodiment of the underlying invention comprises two branches, in which the first branch contains at least one phase shifter and the second branch contains at least two phase shifters, wherein the first end of each particular branch is connected to the first passive N-port network, and the second end of each branch is connected to the second passive N-port network in order to provide a passive isolation of the two RF input signals ($S_1$ and $S_2$).

In addition, the independent claim 13 and the dependent claim 14 relate to a mobile radio receiver comprising a five-port junction device according to anyone of the claims 1 to 12 for a direct downconversion of a received modulated RF input signal ($S_1$).

The independent claim 15 and the dependent claim 16 pertain to a method for supporting a direct downconversion of received modulated RF signals. Thereby, a mobile radio receiver comprising a five-port junction device used for the processing of modulated RF signals according to anyone of the claims 1 to 14 is applied.

Moreover, the dependent claims 17 and 18 refer to a method for providing a calibration of the five-port junction device according to anyone of the claims 1 to 12. Thereby, an isolation of the RF input signals ($S_1$ and $S_2$) is achieved by means of a phase shift of at least one of said RF input signals ($S_1$ and $S_2$). Due to said method it can be ensured that after having performed said phase shifts the obtained values for the phases of said RF input signals ($S_1$ and $S_2$) are different.

Finally, the dependent patent claims 19 to 21 refer to a mobile telecommunications device, wherein a mobile radio receiver according to anyone of the claims 13 and 14, a method for a direct downconversion of received modulated RF signals according to anyone of the claims 15 and 16, and a method for a calibration of a five-port junction device applied to said mobile radio receiver according to anyone of the claims 17 and 18 is employed.

## BRIEF DESCRIPTION OF THE DRAWINGS

Further advantages of the underlying invention result from the subordinate claims as well as from the following description of two preferred embodiments of the invention which are depicted in the following drawings. Herein,

FIG. 1 shows a block diagram 100 giving a general overview of the five-port junction device 102 according to the preferred embodiment of the underlying invention comprising three power detectors 104a-c (according to the state of the art) applied to the proposed topology of Fig. 4,

FIG. 2a shows a block diagram 200 of a non-reciprocal active circuitry 112 for a five-port junction device 102 according to the state of the art providing an isolation between the RF signal ($S_1$) and the LO signal ($S_2$),

FIG. 2b shows a detailed view of the components 114a+b included in the passive four-port network 114 according to the state of the art,

FIG. 2c shows a topology 300 according to the state of the art providing an isolation between the RF signal ($S_1$) and the LO signal ($S_2$) by means of a four-port structure using passive networks 110, 112a-c, 114b and 302a+b,

FIG. 3 shows a topology 300 according to the state of the art providing an isolation between the RF signal ($S_1$) and the LO signal ($S_2$) by means of a five-port structure using passive networks 110, 112a-c, 114a+b and 302a+b,

FIG. 4 exhibits the topology 400 of the proposed five-port junction device 102 according to the preferred embodiment of the underlying invention comprising three phase shifters 112a-c and four passive components 114 and 402a-c in order to enable a splitting and combining of the RF signal ($S_1$) and the LO signal ($S_2$),

FIG. 5 exhibits a possible network realization 500 of the proposed topology 400 presented in Fig. 4 according to

the preferred embodiment of the underlying invention using resistive three-ports 402a-c in order to enable a splitting and combining of the RF signal ($S_1$) and the LO signal ($S_2$),

FIG. 6 exhibits the topology 600 of an analog circuitry (here: a DC amplifier network) according to the preferred embodiment of the underlying invention, in which the nodes $P_3$, $P_4$ and $P_5$ shall be connected with the ports 401c, 401d and 401e, respectively, in order to obtain I/Q output signals with the aid of analog means 602a-f and 604a-d without needing any means for performing a digital signal processing, and

FIG. 7 exhibits the constellation points 700 of a simulated 5 GHz application using a 20 MHz QPSK signal, wherein the values of the employed active elements correspond to a JFET GaAs process.

It should be noted that between the actual connections in Fig. 6 lowpass filters and DC amplifiers can optionally be placed. Furthermore, it should be noted that the constant power value $P_0$ denotes the DC constant which is known from the applied LO power corresponding to the specific choice of the circuit elements as depicted in Fig. 5.

DETAILED DESCRIPTION OF THE UNDERLYING INVENTION

In the following the functions of the structures comprised in a first embodiment of the underlying invention as depicted in Figs. 1 and 4 to 7 are explained.

In Fig. 1 a block diagram is depicted which gives an overview of the applied five-port network. The herein disclosed structure comprises a five-port junction device 102 connected with three power detectors 104a-c according to the state of the art depicted in Fig. 2a. In this structure the five-port junction device 102 acts as an isolation between a received first RF signal ($S_1$) and a second RF signal ($S_2$) originating from a local oscillator (LO). In the following sections $S_1$ shall be called "RF signal", and $S_2$ shall be called "LO signal".

In the following, the method of operation according to the preferred embodiment of the underlying invention shall be described using the example represented by Figs. 4 to 6.

When a single RF input signal ($S_1$) arrives at port 401a of the five-port structure 400, said RF input signal ($S_1$) is split into three partial signals. The first of these partial signals moves towards port 401c, the second continues to propagate towards port 401d of the passive three-port network 402a, and the third continues to propagate towards the third phase shifter 112c and towards port 401e. Thereby, it is important to note that the three phase shifters 112a-c are positioned in such a way that the partial LO signals passing through the upper branch and the lower branch of the five-port structure arrive at ports 401c and 401a with opposite phases (destructive interference), thereby providing the significant improvement of an RF/LO isolation according to the underlying invention. The same applies to the case when the manufacturing tolerances of the employed components have to be considered. Consequently, the solution according to the underlying invention ideally enables that only signal amplitudes of the incoming RF signal ($S_1$) are detected at port 401c. At the ports 401d and 401e, a phase-related combination of the RF signal ($S_1$) and the LO signal ($S_2$) is present, similar to the classic five-port theory with only one chain. Moreover, it should be mentioned that the leakage of the RF signal on its way towards the LO port can be minimized by summing up destructively interfering signals with almost opposite phases. Thereby, the stability of the LO signal ($S_2$) can significantly be increased.

In the following, a brief mathematical description of the method according to the preferred embodiment of the underlying invention yielding the I/Q values of the received signal shall be given.

In the demodulator of the five-port receiver including said five-port junction device 102 the complex-valued ratio S of

the RF signal $S_1 := |S_1| \cdot e^{j \cdot arc(S_1)} \in C\,[\sqrt{W}]$ and

the LO signal $S_2 := |S_2| \cdot e^{j \cdot arc(S_2)} \in C\,[\sqrt{W}]$,

each represented by its amplitude $|S_i|$ and phase $arc(S_i)$ (with the indices i = 1 and i = 2, respectively), is detected:

$$S := \frac{|S_1| \cdot e^{j \cdot arc(S_1)}}{|S_2| \cdot e^{j \cdot arc(S_2)}} = d \cdot e^{j \cdot arc(S)}$$

$$= d \cdot \cos[arc(S)] + j \cdot d \cdot \sin[arc(S)] = I + j \cdot Q \in C, \qquad (1)$$

wherein

| | |
|---|---|
| $d := \lvert S\rvert = \lvert S_1\rvert / \lvert S_2\rvert$ | is the amplitude ratio of the two complex signals $S_1$ and $S_2$, |
| $arc(S) := arc(S_1) - arc(S_2)$ [deg] | is the phase of the ratio S, |

| | |
|---|---|
| $I := Re\{S\} = d \cdot \cos[arc(S)]$ | denotes the inphase signal of the ratio S, |
| $Q := Im\{S\} = d \cdot \sin[arc(S)]$ | denotes the quadrature signal of the ratio S, |
| $j := \sqrt{-1}$ | is the imaginary unit, and |
| $e \approx 2.718281828$ | is the Euler constant. |

The mathematical operations used in equation (1) are defined as follows:

$$|S| := \sqrt{Re^2\{S\} + Im^2\{S\}},$$

and

$$arc(S) := \angle S + k \cdot 360° \text{ [deg] } \forall\, k \in Z$$

wherein

$$\angle S := \begin{cases} \arctan(Im\{S\}/Re\{S\}) & \text{for } Re\{S\} > 0 \text{ and } Im\{S\} > 0 \\ 360° + \arctan(Im\{S\}/Re\{S\}) & \text{for } Re\{S\} > 0 \text{ and } Im\{S\} < 0 \\ 180° + \arctan(Im\{S\}/Re\{S\}) & \text{for } Re\{S\} < 0 \\ 0° & \text{for } Re\{S\} > 0 \text{ and } Im\{S\} = 0 \\ 90° & \text{for } Re\{S\} = 0 \text{ and } Im\{S\} > 0 \\ 180° & \text{for } Re\{S\} < 0 \text{ and } Im\{S\} = 0 \\ 270° & \text{for } Re\{S\} = 0 \text{ and } Im\{S\} < 0 \end{cases}$$

with $\angle S \in [0°;360°[$, thereby assuming that $|S| \neq 0$.

The power level $P_0$ of the LO signal can be calculated with the aid of the following formula:

$$P_0 := |S_2|^2 = P_{ref} \cdot 10^{\frac{P_{LO}[dBm]}{10}} \text{ [W] with } P_{ref} := 50 \text{ mW}. \quad (2)$$

The interdependence of the three phase shift values, $\theta_1$, $\theta_2$ and $\theta_3$, generated by the three phase shifters can be taken from the following equation:

$$\theta_1 := 180° + \theta_2 + \theta_3 + k \cdot 360° \text{ [deg] } \forall\, k \in Z \quad (3).$$

Thereby, it can be ensured that the RF signal ($S_1$) and the LO signal ($S_2$) have opposite phases, since the obtained phase difference of the RF signal ($S_1$) and the LO signal ($S_2$) is given by

$$arc(S_1) - arc(S_2) = 180° + k \cdot 360° \ \forall\, k \in Z.$$

The resistors applied to the solution depicted in Fig. 5 referring to the resistive solution of the proposed topology have the following values:

$$R_0 := 50\ \Omega \quad (4a)$$

and

$$R_1 := 25\ \Omega. \tag{4b}$$

The desired transfer functions of the five-port structure can be taken from the equations (5a) to (5h):

$$k_{21} := 0, \tag{5a}$$

$$k_{12} := 0, \tag{5b}$$

$$k_{31} := |k_{31}| \cdot e^{j \cdot \alpha_{31}} = |k_{31}| \cdot [\cos(\alpha_{31}) + j \cdot \sin(\alpha_{31})], \tag{5c}$$

$$k_{32} := 0, \tag{5d}$$

$$k_{41} := |k_{41}| \cdot e^{j \cdot \alpha_{41}} = |k_{41}| \cdot [\cos(\alpha_{41}) + j \cdot \sin(\alpha_{41})], \tag{5e}$$

$$k_{42} := |k_{42}| \cdot e^{j \cdot \alpha_{42}} = |k_{42}| \cdot [\cos(\alpha_{42}) + j \cdot \sin(\alpha_{42})], \tag{5f}$$

$$k_{51} := |k_{51}| \cdot e^{j \cdot \alpha_{51}} = |k_{51}| \cdot [\cos(\alpha_{51}) + j \cdot \sin(\alpha_{51})], \tag{5g}$$

$$k_{52} := |k_{52}| \cdot e^{j \cdot \alpha_{52}} = |k_{52}| \cdot [\cos(\alpha_{52}) + j \cdot \sin(\alpha_{52})], \tag{5h}$$

wherein $k_{mn}$ is a complex coefficient representing the portion of the signal coming from port #n and measured at port #m (with $n,m \in \{1,2,3,4,5\}$). Thereby, the indices n and m correspond with the reference signs of the port numbers in Fig. 1 and 4, respectively, as follows:

| Port Number Index (n or m) | Reference Sign in Fig. 1 | Reference Sign in Fig. 4 |
|---|---|---|
| 1 | 102a | 401a |
| 2 | 102e | 401b |
| 3 | 102b | 401c |
| 4 | 102c | 401d |
| 5 | 102d | 401e |

With the angles

$$\Delta\alpha_4 := \alpha_{41} - \alpha_{42}\ [\text{deg}] \tag{6a}$$

and

$$\Delta\alpha_5 := \alpha_{51} - \alpha_{52}\ [\text{deg}], \tag{6b}$$

the power values $P_3$, $P_4$ and $P_5$ measured with the aid of power detectors 104a-c (wherein power detectors with ideal characteristics are assumed) at the respective ports 401c, 401d and 401e yield:

$$P_3 := |k_{31} \cdot S_1|^2 = |k_{31}|^2 \cdot |S_1|^2 \text{ [W]}, \quad (7a)$$

$$P_4 := |k_{41} \cdot S_1 + k_{42} \cdot S_2|^2 = |k_{41}|^2 \cdot |S_1|^2 + |k_{42}|^2 \cdot |S_2|^2$$
$$+ 2 \cdot |k_{41}| \cdot |k_{42}| \cdot |S_1| \cdot |S_2| \cdot \cos[\text{arc}(S)+\Delta\alpha_4] \text{ [W]} \quad (7b)$$

and

$$P_5 := |k_{51} \cdot S_1 + k_{52} \cdot S_2|^2 = |k_{51}|^2 \cdot |S_1|^2 + |k_{52}|^2 \cdot |S_2|^2$$
$$+ 2 \cdot |k_{51}| \cdot |k_{52}| \cdot |S_1| \cdot |S_2| \cdot \cos[\text{arc}(S)+\Delta\alpha_5] \text{ [W]} \quad (7c)$$

thereby using

$$\cos^2(x) + \sin^2(x) = 1 \ \forall \ x,y \in R$$

and

$$\cos(x-y) = \cos(x) \cdot \cos(y) + \sin(x) \cdot \sin(y) \ \forall \ x,y \in R \ (*).$$

In matrix-vector form the equations (7a) to (7c) can be written as

$$\underline{P} := (\underline{\underline{T}} \cdot \underline{S})^H (\underline{\underline{T}} \cdot \underline{S}) = \underline{S}^H (\underline{\underline{T}}^H \ \underline{\underline{T}}) \underline{S} \text{ [W]},$$

wherein

$\underline{S} := [S_1,S_2,S_3,S_4,S_5]^T \in C^5 [\sqrt{W}]$ denotes the signal vector,

$\underline{P} := [P_1,P_2,P_3,P_4,P_5]^T \in R^5$ [W] denotes the power vector,

$$\underline{\underline{T}} := \begin{pmatrix} * & 0 & * & * & * \\ 0 & * & * & * & * \\ k_{31} & 0 & * & * & * \\ k_{41} & k_{42} & * & * & * \\ k_{51} & k_{52} & * & * & * \end{pmatrix} \in C^{5\times 5}$$

is the transfer matrix, and

'H' denotes the complex conjugate transpose operation (Hermitian transpose).

Using equations (7a) to (7c) and (*), a linear 2x2 equation system comprising two linearly independent equations (8a) and (8b) for the two unknowns I and Q can be obtained:

$$d \cdot \cos(\text{arc}(S)+\Delta\alpha_4) = I \cdot \cos(\Delta\alpha_4) - Q \cdot \sin(\Delta\alpha_4)$$

$$= \frac{P_4 - \frac{|k_{41}|^2}{|k_{31}|^2} \cdot P_3 - |k_{42}|^2 \cdot P_0}{2 \cdot |k_{41}| \cdot |k_{42}| \cdot P_0} \qquad (8a)$$

and

$$d \cdot \cos(\mathrm{arc}(S) + \Delta\alpha_5) = I \cdot \cos(\Delta\alpha_5) - Q \cdot \sin(\Delta\alpha_5)$$

$$= \frac{P_5 - \frac{|k_{51}|^2}{|k_{31}|^2} \cdot P_3 - |k_{52}|^2 \cdot P_0}{2 \cdot |k_{51}| \cdot |k_{52}| \cdot P_0}. \qquad (8b)$$

The solution of this equation system yields the desired I and Q values as follows:

$$I = \frac{d \cdot \cos[\mathrm{arc}(S) + \Delta\alpha_5] \cdot \sin(\Delta\alpha_4) - d \cdot \cos[\mathrm{arc}(S) + \Delta\alpha_4] \cdot \sin(\Delta\alpha_5)}{\sin(\Delta\alpha_4 - \Delta\alpha_5)} =$$

$$\frac{\frac{P_5 - \frac{|k_{51}|^2}{|k_{31}|^2} \cdot P_3 - |k_{52}|^2 \cdot P_0}{2 \cdot |k_{51}| \cdot |k_{52}| \cdot P_0} \cdot \sin(\Delta\alpha_4) - \frac{P_4 - \frac{|k_{41}|^2}{|k_{31}|^2} \cdot P_3 - |k_{42}|^2 \cdot P_0}{2 \cdot |k_{41}| \cdot |k_{42}| \cdot P_0} \cdot \sin(\Delta\alpha_5)}{\sin(\Delta\alpha_4 - \Delta\alpha_5)} \qquad (9a)$$

and

$$Q = \frac{d \cdot \cos[\mathrm{arc}(S) + \Delta\alpha_5] \cdot \cos(\Delta\alpha_4) - d \cdot \cos[\mathrm{arc}(S) + \Delta\alpha_4] \cdot \cos(\Delta\alpha_5)}{\sin(\Delta\alpha_4 - \Delta\alpha_5)} =$$

$$\frac{\frac{P_5 - \frac{|k_{51}|^2}{|k_{31}|^2} \cdot P_3 - |k_{52}|^2 \cdot P_0}{2 \cdot |k_{51}| \cdot |k_{52}| \cdot P_0} \cdot \cos(\Delta\alpha_4) - \frac{P_4 - \frac{|k_{41}|^2}{|k_{31}|^2} \cdot P_3 - |k_{42}|^2 \cdot P_0}{2 \cdot |k_{41}| \cdot |k_{42}| \cdot P_0} \cdot \cos(\Delta\alpha_5)}{\sin(\Delta\alpha_4 - \Delta\alpha_5)}, \qquad (9b)$$

thereby using

$$\sin(x - y) = \sin(x) \cdot \cos(y) - \cos(x) \cdot \sin(y) \quad \forall\, x, y \in \Re.$$

By setting

$$\Delta\alpha_4 := 90° + k \cdot 360° \quad \forall\, k \in Z \qquad (10a)$$

and

$$\Delta\alpha_5 := 0° + k \cdot 360° \quad \forall\, k \in Z \qquad (10b),$$

equations (9a) and (9b) can be simplified as follows:

$$I = \frac{P_5 - \frac{|k_{51}|^2}{|k_{31}|^2} \cdot P_3 - |k_{52}|^2 \cdot P_0}{2 \cdot |k_{51}| \cdot |k_{52}| \cdot P_0} \tag{11a}$$

and

$$Q = -\frac{P_4 - \frac{|k_{41}|^2}{|k_{31}|^2} \cdot P_3 - |k_{42}|^2 \cdot P_0}{2 \cdot |k_{41}| \cdot |k_{42}| \cdot P_0}. \tag{11b}$$

Taking into account equations (3), (4a) and (4b), the theoretical transfer functions of the five-port structure depicted in Fig. 5 can be obtained after a long mathematical calculation as follows:

$$k_{31} = \frac{1}{3} \cdot \left(1 - \frac{2 \cdot e^{j \cdot 2 \cdot \theta_1}}{24 + e^{j \cdot 2 \cdot \theta_1}}\right), \tag{12a}$$

$$k_{32} = 0, \tag{12b}$$

$$k_{41} = \frac{4 - e^{j \cdot 2 \cdot \theta_1}}{24 + e^{j \cdot 2 \cdot \theta_1}}, \tag{12c}$$

$$k_{42} = \frac{5 \cdot e^{j \cdot \theta_1}}{24 + e^{j \cdot 2 \cdot \theta_1}}, \tag{12d}$$

$$k_{51} = \frac{e^{j \cdot (\theta_1 + \theta_2)} - 4 \cdot e^{j \cdot (\theta_1 - \theta_2)}}{24 + e^{j \cdot 2 \cdot \theta_1}} \tag{12e}$$

and

$$k_{52} = \frac{6 \cdot e^{j \cdot \theta_2} - e^{j \cdot (2 \cdot \theta_1 - \theta_2)}}{24 + e^{j \cdot 2 \cdot \theta_1}}. \tag{12f}$$

From the equations (10a) and (10b) the theoretical requirements for the phase shifter values ($\theta_1$, $\theta_2$ and $\theta_3$) can be derived as follows:

$$\begin{aligned} \Delta\alpha_4 &= \operatorname{arc}\left(\frac{k_{41}}{k_{42}}\right) \\ &= \operatorname{arc}\left(4 - e^{j \cdot 2 \cdot \theta_1}\right) - \operatorname{arc}\left(5 \cdot e^{j \cdot \theta_1}\right) = 90^\circ \end{aligned} \tag{13a}$$

and

$$\Delta\alpha_5 = \mathrm{arc}\left(\frac{k_{51}}{k_{52}}\right) = \mathrm{arc}\left(e^{j\cdot(\theta_1+\theta_2)} - 4\cdot e^{j\cdot(\theta_1-\theta_2)}\right) - \mathrm{arc}\left(6\cdot e^{j\cdot\theta_2} - e^{j\cdot(2\cdot\theta_1-\theta_2)}\right) = 0°, \quad (13b)$$

yielding

$$\theta_1 = -90° + k\cdot 360° \quad \forall\, k \in Z,$$

$$\theta_2 \approx +42.50573° + k\cdot 360° \ \forall\, k \in Z$$

and

$$\theta_3 \approx +47.49427° + k\cdot 360° \ \forall\, k \in Z,$$

In a special case of equations (13a) and (13b) said phase shift values are given by

$$\theta_1 = 270°, \quad (14a)$$

$$\theta_2 \approx 42.50573° \quad (14b)$$

and

$$\theta_3 \approx 47.49427°, \quad (14c)$$

thereby yielding

$$k_{31} = 0.36232\cdot e^{j\cdot 0°} = 0.36232 + j\cdot 0.00000, \quad (15a)$$

$$k_{32} = 0 = 0.00000 + j\cdot 0.00000, \quad (15b)$$

$$k_{41} = 0.21739\cdot e^{j\cdot 0°} = 0.21739 + j\cdot 0.00000, \quad (15c)$$

$$k_{42} = 0.21739\cdot e^{-j\cdot 90°} = 0.00000 - j\cdot 0.21739 \quad (15d)$$

$$k_{51} = 0.17555\cdot e^{j\cdot 33.21618°} = 0.14687 + j\cdot 0.09617, \quad (15e)$$

$$k_{52} = 0.26818\cdot e^{j\cdot 33.20564°} = 0.22439 + j\cdot 0.14687, \quad (15f)$$

wherein Euler's formula

$$e^{j \cdot \varphi} = \cos(\varphi) + j \cdot \sin(\varphi) \ \forall \ \varphi \in [0°;360°]$$

is applied. These phase shift values ($\theta_1$, $\theta_2$ and $\theta_3$) and transfer functions ($k_{31}$, $k_{32}$, $k_{41}$, $k_{42}$, $k_{51}$ and $k_{52}$) are used to verify the simulation results of the proposed five-port topology solution according to the underlying invention. They correspond to the network realization as depicted in Fig. 5.

In order to provide direct analog I/Q output signals by connecting the analog circuitry 600 depicted in Fig. 6 to the DC interface 101a, special gains $g_1$, $g_2$, $g_3$, $g_4$, $g_5$ and $g_6$ for the employed DC amplifiers 602a-f are proposed:

$$g_1 := \frac{|k_{51}|^2}{|k_{31}|^2}, \tag{16a}$$

$$g_2 := \frac{|k_{41}|^2}{|k_{31}|^2}, \tag{16b}$$

$$g_3 := |k_{52}|^2, \tag{16c}$$

$$g_4 := |k_{42}|^2, \tag{16d}$$

$$g_5 := \frac{1}{2 \cdot |k_{51}| \cdot |k_{52}| \cdot P_0} \tag{16e}$$

$$g_6 := \frac{1}{2 \cdot |k_{41}| \cdot |k_{42}| \cdot P_0}. \tag{16f}$$

Thus, equations (11a) and (11b) can be written as follows:

$$I = g_5 \cdot (P_5 - g_1 \cdot P_3 - g_3 \cdot P_0)$$

and

$$Q = - g_6 \cdot (P_4 - g_2 \cdot P_3 - g_4 \cdot P_0) = g_6 \cdot (-P_4 + g_2 \cdot P_3 + g_4 \cdot P_0).$$

It must be noted that in praxis k coefficients may be provided for the I/Q calculation by means of a calibration process, in which different RF signals having different phase values and power levels are simultaneously fed to the circuitry 600 along with already known LO signals with different power levels.

The simulation results of an application using a carrier frequency of 5.5 GHz can be taken from the elements of the scattering matrix $\underline{\underline{S}} \in C^{5 \times 5}$ in the equation $\underline{b} = \underline{\underline{S}} \cdot \underline{a}$, wherein
$\underline{a} := [a_1,a_2,a_3,a_4,a_5]^T \in C^5$ denotes the input wave vector and
$\underline{b} := [b_1,b_2,b_3,b_4,b_5]^T \in C^5$ denotes the output wave vector
of the five-port junction device 102. In this simulation the obtained scattering matrix S is given by

$$\underline{\underline{S}} := \begin{pmatrix} S_{11} & S_{12} & S_{13} & S_{14} & S_{15} \\ S_{21} & S_{22} & S_{23} & S_{24} & S_{25} \\ S_{31} & S_{32} & S_{33} & S_{34} & S_{35} \\ S_{41} & S_{42} & S_{43} & S_{44} & S_{45} \\ S_{51} & S_{52} & S_{53} & S_{54} & S_{55} \end{pmatrix} =$$

$$\begin{pmatrix} -30.76 \cdot e^{j\cdot 0°} & * & * & * & * \\ -326.36 \cdot e^{j\cdot 152.49°} & -27.23 \cdot e^{j\cdot 0°} & * & * & * \\ -8.82 \cdot e^{j\cdot 0°} & -324.25 \cdot e^{-j\cdot 144.56°} & -30.76 \cdot e^{j\cdot 0°} & * & * \\ -13.26 \cdot e^{j\cdot 0°} & -13.26 \cdot e^{-j\cdot 90°} & * & -27.23 \cdot e^{j\cdot 0°} & * \\ -15.11 \cdot e^{j\cdot 33.21°} & -11.43 \cdot e^{j\cdot 33.21°} & * & * & -27.23 \cdot e^{j\cdot 0°} \end{pmatrix}$$

with $S_{mn}$ [dB] $\forall$ m,n $\in$ {1,2,3,4,5}.

Thereby, GaAs power detectors are applied. Furthermore, it shall be assumed that ideal phase shifters 112a-c are applied according to the special case as given by equations (4a), (4b), (10a) and (10b). On these assumptions, it can be observed that the input ports 401a+b are well matched and that the achieved RF/LO isolation is ideal. Although manufacturing tolerances of the employed components could impair the matching and isolation performance, the performance of the isolation remains stable during the entire simulation even in that case.

Fig. 7 exhibits the constellation points of the underlying QPSK signal of 20 MHz for a simulated application at a carrier frequency of 5 GHz, wherein the values of the employed active elements correspond to a JFET GaAs process.

The significance of the symbols designated with reference signs in the Figs. 1 to 7 can be taken from the appended table of reference signs.

| Table of the depicted features and their corresponding reference signs | |
|---|---|
| No. | Feature |
| 100 | block diagram showing a general overview of the five-port structure comprising three power detectors for the detection of three power values $P_3$, $P_4$ and $P_5$ (according to the state of the art) applied to the proposed topology of Fig. 4 (according to the preferred embodiment of the underlying invention) |
| 101a | direct current (DC) interface |
| 101b | digital signal processor (DSP) |
| 102 | five-port junction device |
| 102a | 1st port of the five-port junction device 102 |
| 102e | 2nd port of the five-port junction device 102 |
| 102b | 3rd port of the five-port junction device 102 |
| 102c | 4th port of the five-port junction device 102 |
| 102d | 5th port of the five-port junction device 102 |
| 104a | 1st power detector needed for the detection of the power $P_3$ |
| 104b | 2nd power detector needed for the detection of the power $P_4$ |
| 104c | 3rd power detector needed for the detection of the power $P_5$ |

(continued)

| Table of the depicted features and their corresponding reference signs | |
|---|---|
| No. | Feature |
| 106a | power sensor of the 1st power detector 104a |
| 106b | power sensor of the 2nd power detector 104b |
| 106c | power sensor of the 3rd power detector 104c |
| 108a | lowpass (LP) filter of the 1st power detector 104a |
| 108b | lowpass (LP) filter of the 2nd power detector 104b |
| 108c | lowpass (LP) filter of the 3rd power detector 104c |
| 110 | passive three-port network comprising resistive components |
| 112 | non-reciprocal active circuitry comprising at least one phase shifter applied to serve as an isolation between the RF signal ($S_1$) and the LO signal ($S_2$) |
| 112a | 1st phase shifter of the non-reciprocal active circuitry 112 providing a phase shift $\theta_1$ |
| 112b | 2nd phase shifter of the non-reciprocal active circuitry 112 providing a phase shift $\theta_2$ |
| 112c | 3rd phase shifter of the non-reciprocal active circuitry 112 providing a phase shift $\theta_3 := \theta_1 - \theta_2 - 180°$ (or: phase shift of 180° obtained by using two phase shifters 112a and 112b providing a phase shift $\theta_1$ and a phase shift $\theta_2 := \theta_1 -180°$) |
| 114 | passive four-port network comprising resistive components |
| 114a | passive power divider included in the passive four-port network 114 |
| 114b | passive three-port network comprising resistive components included in the passive four-port network 114 |
| 200 | block diagram of a circuitry providing an isolation between the RF and LO signal for a five-port junction by means of active devices (according to the state of the art) |
| 300 | topology providing an isolation between the RF signal ($S_1$) and the LO signal ($S_2$) for a four-port by means of passive devices (according to the state of the art) |
| 302a | passive power divider for the RF signal ($S_1$) |
| 302b | passive power divider for the LO signal ($S_2$) |
| 400 | topology of the proposed five-port junction device comprising three phase shifters and four passive components in order to enable a splitting and combining of the RF and LO signal (according to the preferred embodiment of the underlying invention) |
| 401a | port #1 of the five-port junction device 400 |
| 401b | port #2 of the five-port junction device 400 |
| 401c | port #3 of the five-port junction device 400 |
| 401d | port #4 of the five-port junction device 400 |
| 401e | port #5 of the five-port junction device 400 |
| 402a | 1st passive three-port network comprising resistive components |
| 402b | 2nd passive three-port network comprising resistive components |
| 402c | 3rd passive three-port network comprising resistive components |
| 500 | possible network realization of the proposed topology 400 using resistive three-ports in order to enable a splitting and combining of the RF and LO signal |
| 600 | topology of an analog circuitry (a DC amplifier network), in which the nodes $P_3$, $P_4$ and $P_5$ shall be connected with the ports 401c, 401d and 401e in the network realization 500, respectively, in order to obtain I/Q output signals with the aid of analog means without needing any means for performing a digital signal processing |

(continued)

| Table of the depicted features and their corresponding reference signs | |
|---|---|
| No. | Feature |
| 602a | 1st amplifier (gain: $g_1$) used for amplifying the detected power value $P_3$ |
| 602b | 2nd amplifier (gain: $g_2$) used for amplifying the detected power value $P_3$ |
| 602c | 3rd amplifier (gain: $g_3$) used for amplifying the detected power value $P_0$ |
| 602d | 4th amplifier (gain: $g_4$) used for amplifying the detected power value $P_0$ |
| 602e | 5th amplifier (gain: $g_5$) used to obtain the inphase (I) value of a received signal at the output port of said analog circuitry 600 |
| 602f | 6th amplifier (gain: $g_6$) used to obtain the quadrature (Q) value of a received signal at the output port of said analog circuitry 600 |
| 604a | 1st summation element having one inverting input and one non-inverting input |
| 604b | 2nd summation element having one inverting input and one non-inverting input |
| 604c | 3rd summation element having one inverting input and one non-inverting input |
| 604d | 4th summation element having one inverting input and one non-inverting input |
| 700 | constellation points of a simulated 5 GHz application using a 20 MHz QPSK signal, wherein the values of the employed active elements correspond to a JFET GaAs process |

**Claims**

**1.** A five-port junction device used for processing modulated RF signals received by a mobile radio receiver, wherein said five-port junction device (102) comprises:

- at least two RF input ports (401a+b) for two RF input signals ($S_1$ and $S_2$),
- at least three output ports (401c-e) for outputting signals representing three detected power levels ($P_3$, $P_4$, and $P_5$),
- a first (114) and a second passive N-port network (402b) connected to each other by a non-reciprocal circuitry (112), wherein each of said passive N-port networks (114 and 402b) is connected to a different one of said RF input ports (401a+b) and said first passive N-port network (114) comprises an output port (401c) for a signal representing a first output power level ($P_3$), and
- at least three power detectors (104a-c) for detecting the respective power levels ($P_3$, $P_4$, and $P_5$) of said output signals,

wherein

- said non-reciprocal circuitry (112) comprises two branches, the first branch containing at least one phase shifter (112a) as well as a first passive three-port network (402a) having an output port (401d) for a signal representing a second output power level ($P_4$) and the second branch containing at least two phase shifters (112b+c) as well as a second passive three-port network (402c) having an output port (401e) for a signal representing a third output power level ($P_5$),
- the first end of each particular branch is connected to the first passive N-port network (114) and the second end of each branch is connected to the second passive N-port network (402b) to provide a passive isolation of the two RF input signals ($S_1$ and $S_2$),

**characterized in that**
each of said three-port networks (402a+c) is connected to the second passive N-port network (402b) by at least one phase shifter (112a or 112b, respectively).

**2.** A five-port junction device according to claim 1,
**characterized in that**

the first passive N-port network (114) is realized as a passive four-port network.

**3.** A five-port junction device according to anyone of the claims 1 or 2,
**characterized in that**
the second passive N-port network (402b) is realized as a passive three-port network.

**4.** A five-port junction device according to anyone of the claims 1 to 3,
**characterized in that**
the first passive N-port network (114) comprises one input port (401a) for the input of a first RF input signal ($S_1$).

**5.** A five-port junction device according to anyone of the claims 1 to 4,
**characterized in that**
the second passive N-port network (402b) comprises one input port (401b) for the input of a second RF input signal ($S_2$).

**6.** A five-port junction device according to anyone of the claims 1 to 5,
**characterized in that**
one of the RF input ports (401b) is supplied with an RF input signal ($S_2$) originating from a local oscillator.

**7.** A five-port junction device according to anyone of the claims 1 to 6,
**characterized in that**
the phase shift angles ($\theta_1$, $\theta_2$ and $\theta_3$) of three phase shifters (112a-c) satisfy the equation

$$\theta_1 := 180° + \theta_2 + \theta_3 + k \cdot 360°,$$

wherein k is an arbitrary integer value,
in order to obtain RF input signals ($S_1$ and $S_2$) with opposite phases for providing an isolation of said RF input signals ($S_1$ and $S_2$).

**8.** A five-port junction device according to claim 7,
**characterized in that**
the phase shift angles $\theta_1$ and $\theta_3$ satisfy the following two equations:

$$\mathrm{arc}\left(4 - e^{j \cdot 2 \cdot \theta_1}\right) - \mathrm{arc}\left(5 \cdot e^{j \cdot \theta_1}\right) = 90°$$

and

$$\mathrm{arc}\left(e^{j \cdot (\theta_1 + \theta_2)} - 4 \cdot e^{j \cdot (\theta_1 - \theta_2)}\right) - \mathrm{arc}\left(6 \cdot e^{j \cdot \theta_2} - e^{j \cdot (2 \cdot \theta_1 - \theta_2)}\right) = 0°,$$

thereby yielding

$$\theta_1 = -90° + k \cdot 360° \qquad \forall\, k \in \mathbb{Z},$$

$$\theta_2 \approx +42.50573° + k \cdot 360° \qquad \forall\, k \in \mathbb{Z},$$

and

$$\theta_3 \approx +47.49427° + k \cdot 360° \quad \forall k \in \mathbb{Z},$$

wherein

$$arc(S) := \angle S + k \cdot 360° \text{ [deg] } \forall k \in \odot$$

with

$$\angle S := \begin{cases} \arctan(\mathrm{Im}\{S\}/\mathrm{Re}\{S\}) & \text{for } \mathrm{Re}\{S\}>0 \text{ and } \mathrm{Im}\{S\}>0 \\ 360° + \arctan(\mathrm{Im}\{S\}/\mathrm{Re}\{S\}) & \text{for } \mathrm{Re}\{S\}>0 \text{ and } \mathrm{Im}\{S\}<0 \\ 180° + \arctan(\mathrm{Im}\{S\}/\mathrm{Re}\{S\}) & \text{for } \mathrm{Re}\{S\}<0 \\ 0° & \text{for } \mathrm{Re}\{S\}>0 \text{ and } \mathrm{Im}\{S\}=0 \\ 90° & \text{for } \mathrm{Re}\{S\}=0 \text{ and } \mathrm{Im}\{S\}>0 \\ 180° & \text{for } \mathrm{Re}\{S\}<0 \text{ and } \mathrm{Im}\{S\}=0 \\ 270° & \text{for } \mathrm{Re}\{S\}=0 \text{ and } \mathrm{Im}\{S\}<0 \end{cases}$$

denotes the argument of a complex-valued signal S given in the form $S = |S| \cdot e^{j \cdot arc(S)}$ ($|S| \neq 0$).

**9.** A five-port junction device according to anyone of the claims 1 to 8,
**characterized in that**
at least one of the passive N-port networks (114 and 402a-c) is realized by means of a resistive network.

**10.** A five-port junction device according to anyone of the claims 1 to 9,
**characterized by**
a DC amplifier network (600) being connected to at least three ports (401c-e) of said five-port junction device (102) to obtain the in-phase (I) and quadrature (Q) component of the received RF input signal ($S_1$).

**11.** A mobile radio receiver,
**characterized by**
a five-port junction device (102) according to anyone of the claims 1 to 10 being specially designed for a direct down-conversion of a received modulated RF input signal ($S_1$).

**12.** A mobile radio receiver according to claim 11,
**characterized in that**
said five-port junction device (102) comprises means for performing a direct down-conversion of a received n-PSK-, 2-QAM- or OFDM-modulated RF input signal ($S_1$).

**13.** A method for supporting a direct down-conversion of received modulated RF signals,
**characterized in that**
a mobile radio receiver comprising a five-port junction device (102) used for the processing of modulated RF signals according to anyone of the claims 1 to 10 is applied, comprising the following steps:

- input of two RF input signals ($S_1$ and $S_2$) to said five-port receiver,
- output of three output signals being based on linear combinations of said two RF input signals ($S_1$ and $S_2$), and
- detection of the power levels ($P_3$, $P_4$ and $P_5$) of said three output signals.

**14.** A method according to claim 13,

**characterized in that**
a complex linear transformation is applied to calculate the correct modulation state values of a first RF input signal ($S_1$) represented by the in-phase signal (I) and the quadrature signal (Q) of said first RF input signal ($S_1$) on the basis of actually detected power values ($P_3$, $P_4$ and $P_5$), wherein the coefficients of said complex linear transformation are calculated by comparing predefined modulation states of a second RF input signal ($S_2$) used as a calibration signal with the actually detected power values ($P_3$, $P_4$ and $P_5$).

**15.** A method arranged to provide a calibration of the five-port junction device (102) according to anyone of the claims 1 to 10,
**characterized in that**
an isolation of the RF input signals ($S_1$ and $S_2$) is achieved by means of a phase shift of at least one of said RF input signals ($S_1$ and $S_2$), thereby ensuring that after having performed said phase shifts the phase of the first RF input signal ($S_1$) differs from the phase of the second RF signal ($S_2$).

**16.** A method according to claim 15,
**characterized in that**
three phase shifts are performed using the phase shift angles ($\theta_1$, $\theta_2$ and $\theta_3$) of three phase shifters (112a-c) satisfying the equation

$$\theta_1 := 180° + \theta_2 + \theta_3 + k \cdot 360°,$$

wherein k is an arbitrary integer value,
in order to obtain RF input signals ($S_1$ and $S_2$) with opposite phases for providing an isolation of said RF input signals ($S_1$ and $S_2$).

**17.** A method according to claim 16,
**characterized in that**
the phase shift angles $\theta_1$ and $\theta_3$ satisfy the following two equations:

$$\mathrm{arc}\left(4 - e^{j \cdot 2 \cdot \theta_1}\right) - \mathrm{arc}\left(5 \cdot e^{j \cdot \theta_1}\right) = 90°$$

and

$$\mathrm{arc}\left(e^{j \cdot (\theta_1 + \theta_2)} - 4 \cdot e^{j \cdot (\theta_1 - \theta_2)}\right) - \mathrm{arc}\left(6 \cdot e^{j \cdot \theta_2} - e^{j \cdot (2 \cdot \theta_1 - \theta_2)}\right) = 0°,$$

thereby yielding

$$\theta_1 = -90° + k \cdot 360° \qquad \forall\, k \in \mathbb{Z},$$

$$\theta_2 \approx +42.50573° + k \cdot 360° \qquad \forall\, k \in \mathbb{Z},$$

and

$$\theta_3 \approx +47.49427° + k \cdot 360° \qquad \forall\, k \in \mathbb{Z},$$

wherein

$$\mathrm{arc}(S) := \angle S + k\cdot 360° \text{ [deg] } \forall k \in \odot$$

with

$$\angle S := \begin{cases} \arctan(\mathrm{Im}\{S\}/\mathrm{Re}\{S\}) & \text{for } \mathrm{Re}\{S\}>0 \text{ and } \mathrm{Im}\{S\}>0 \\ 360° + \arctan(\mathrm{Im}\{S\}/\mathrm{Re}\{S\}) & \text{for } \mathrm{Re}\{S\}>0 \text{ and } \mathrm{Im}\{S\}<0 \\ 180° + \arctan(\mathrm{Im}\{S\}/\mathrm{Re}\{S\}) & \text{for } \mathrm{Re}\{S\}<0 \\ 0° & \text{for } \mathrm{Re}\{S\}>0 \text{ and } \mathrm{Im}\{S\}=0 \\ 90° & \text{for } \mathrm{Re}\{S\}=0 \text{ and } \mathrm{Im}\{S\}>0 \\ 180° & \text{for } \mathrm{Re}\{S\}<0 \text{ and } \mathrm{Im}\{S\}=0 \\ 270° & \text{for } \mathrm{Re}\{S\}=0 \text{ and } \mathrm{Im}\{S\}<0 \end{cases}$$

denotes the argument of a complex-valued signal S given in the form $S = |S|\cdot e^{j\cdot \mathrm{arc}(S)}$ ($|S| \neq 0$).

**18.** A method according to anyone of the claims 14 to 17,
**characterized in that**
said in-phase (I) and quadrature (Q) signals are calculated by a linear combination of two different pairs of power levels (($P_3$, $P_5$) and ($P_3$, $P_4$)) which are detected at the three output ports (401c-e) of the proposed five-port junction device (102).

**19.** A method according to claim 18,
**characterized in that**
the in-phase signal (I) is calculated as a function ($f_1$) of the power levels ($P_3$ and $P_5$) detected at the output ports (104c+e) of the first passive N-port network (114) and the second passive three-port network (402c), respectively, and the quadrature signal (Q) is calculated as a function ($f_2$) of the power levels ($P_3$ and $P_4$) detected at the output ports (104c+d) of the first passive N-port network (114) and the first passive three-port network (402a), respectively, according to the following equations:

$$I = f_1(P_3,P_5) = g_5\cdot(P_5 - g_1\cdot P_3 - g_3\cdot P_0)$$

and

$$Q = f_2(P_3,P_4) = g_6\cdot(-P_4 + g_2\cdot P_3 + g_4\cdot P_0)$$

with $g_1, g_2, ..., g_6 \in \mathbb{R}$ and

$$P_0 := |S_2|^2 = 50\text{ mW}\cdot 10^{\frac{P_{LO}\text{ [dBm]}}{10}},$$

wherein

| | |
|---|---|
| $P_0$ [mW] | denotes the power level of the RF signal ($S_2$) generated by the local oscillator (LO) and |
| $g_1,...,g_6$ | are the gain factors of the DC amplifiers (602a-f) used in the DC amplifier network (600) connected to the three output ports (401c-e) of the five-port junction device (102), which are derived from the complex-valued transfer coefficients ($k_{mn}$) of the five-port junction device (102) (with the indices m, n ∈ {1, 2, ..., 5}), said transfer coefficients ($k_{mn}$) representing the portion of an RF signal coming from port #n which is measured at port #m. |

**20.** A mobile telecommunication device, comprising a mobile radio receiver according to anyone of the claims 11 or 12 is applied.

**21.** A mobile telecommunication device, **characterized by** means arranged to perform a method according to anyone of the claims 13 or 14.

**22.** A mobile telecommunication device, comprising a mobile radio receiver using a five-port junction device (102) according to anyone of the claims 1 to 10, **characterized by** means arranged to perform a method according to anyone of the claims 15 to 19.

## Patentansprüche

**1.** Fünf Anschlüsse aufweisende Verbindungsvorrichtung, die zur Verarbeitung von modulierten HF-Signalen verwendet wird, welche von einem mobilen Funkempfänger empfangen werden, wobei die betreffende fünf Anschlüsse aufweisende Verbindungsvorrichtung (102) umfasst:

- zumindest zwei HF-Eingangsanschlüsse (401a+b) für zwei HF-Eingangssignale ($S_1$ und $S_2$),
- zumindest drei Ausgangsanschlüsse (401c-e) zur Abgabe von Signalen, die drei ermittelte Leistungspegel ($P_3$, $P_4$ und $P_5$) repräsentieren,
- ein erstes und ein zweites passives N-Anschluss-Netzwerk (114 bzw. 402b), wobei die betreffenden Netzwerke durch eine nicht-reziproke Schaltungsanordnung (112) miteinander verbunden sind, wobei jedes der betreffenden passiven N-Anschluss-Netzwerke (114 und 402b) mit einem anderen der betreffenden HF-Eingangsanschlüsse (401a+b) verbunden ist und wobei das genannte erste passive N-Anschluss-Netzwerk (114) einen Ausgangsanschluss (401c) für ein Signal umfasst, welches einen ersten Ausgangs-Leistungspegel ($P_3$) repräsentiert, und
- zumindest drei Leistungsdetektoren (104a-c) zur Ermittlung der jeweiligen Leistungspegel ($P_3$, $P_4$ und $P_5$) der genannten Ausgangssignale,

wobei

- die genannte nicht-reziproke Schaltungsanordnung (112) zwei Zweige aufweist, von denen der erste Zweig zumindest einen Phasenschieber (112a) sowie ein erstes passives, drei Anschlüsse aufweisendes Netzwerk (402a) mit einem Ausgangsanschluss (401d) für ein Signal enthält, welches einen zweiten Ausgangs-Leistungspegel ($P_4$) repräsentiert, und von denen der zweite Zweig zumindest zwei Phasenschieber (112b+c) sowie ein zweites passives, drei Anschlüsse aufweisendes Netzwerk (402c) mit einem Ausgangsanschluss (401e) für ein Signal enthält, welches einen dritten Ausgangs-Leistungspegel ($P_5$) repräsentiert,
- das erste Ende jedes einzelnen Zweiges mit dem ersten passiven N-Anschluss-Netzwerk (114) verbunden ist und das zweite Ende jedes Zweiges mit dem zweiten passiven N-Anschluss-Netzwerk (402b) verbunden ist, um für eine passive Trennung der beiden HF-Eingangssignale ($S_1$ und $S_2$) zu sorgen,

**dadurch gekennzeichnet, dass** jedes der genannten drei Anschlüsse aufweisenden Netzwerke (402a+c) mit dem zweiten passiven N-Anschluss-Netzwerk (402b) über zumindest einen Phasenschieber (112a bzw. 112b) verbunden ist.

**2.** Fünf Anschlüsse aufweisende Verbindungsvorrichtung nach Anspruch 1, **dadurch gekennzeichnet, dass** das erste passive N-Anschluss-Netzwerk (114) als passives vier Anschlüsse aufweisendes Netzwerk realisiert ist.

**3.** Fünf Anschlüsse aufweisende Verbindungsvorrichtung nach Anspruch 1 oder 2, **dadurch gekennzeichnet, dass** das zweite passive N-Anschluss-Netzwerk (402b) als passives, drei Anschlüsse aufweisendes Netzwerk realisiert ist.

**4.** Fünf Anschlüsse aufweisende Verbindungsvorrichtung nach einem der Ansprüche 1 bis 3, **dadurch gekennzeichnet, dass** das erste passive N-Anschluss-Netzwerk (114) einen Eingangsanschluss (401a) für die Eingabe eines ersten HF-Eingangssignals ($S_1$) aufweist.

**5.** Fünf Anschlüsse aufweisende Verbindungsvorrichtung nach einem der Ansprüche 1 bis 4, **dadurch gekennzeichnet, dass** das zweite passive N-Anschluss-Netzwerk (402b) einen Eingangsanschluss (401b) für die Eingabe eines zweiten HF-Eingangssignals ($S_2$) aufweist.

**6.** Fünf Anschlüsse aufweisende Verbindungsvorrichtung nach einem der Ansprüche 1 bis 5, **dadurch gekennzeichnet, dass** einem der HF-Eingangsanschlüsse (401b) ein von einem örtlichen Oszillator ausgehendes HF-Eingangssignal ($S_2$) zugeführt wird.

**7.** Fünf Anschlüsse aufweisende Verbindungsvorrichtung nach einem der Ansprüche 1 bis 6, **dadurch gekennzeichnet, dass** die Phasenschieberwinkel ($\theta_1$, $\theta_2$ und $\theta_3$) von drei Phasenschiebern (112a-c) der Gleichung

$$\theta_1 := 180° + \theta_2 + \theta_3 + k \cdot 360°$$

genügen, wobei k ein beliebiger ganzzahliger Wert ist, um HF-Eingangssignale ($S_1$ und $S_2$) mit entgegengesetzten Phasen zur Schaffung einer Trennung der betreffenden HF-Eingangssignale ($S_1$ und $S_2$) zu erzielen.

**8.** Fünf Anschlüsse aufweisende Verbindungsvorrichtung nach Anspruch 7, **dadurch gekennzeichnet, dass** die Phasenschieberwinkel $\theta_1$ und $\theta_3$ den folgenden zwei Gleichungen genügen:

$$\mathrm{arc}(4\text{-}e^{j \cdot 2 \cdot \theta_1}) - \mathrm{arc}(5 \cdot e^{j \cdot \theta_1}) = 90°$$

und

$$\mathrm{arc}(e^{j(\theta_1+\theta_2)} - 4 \cdot e^{j(\theta_1-\theta_2)}) - \mathrm{arc}(6 \cdot e^{j\theta_2} - e^{j(2 \cdot \theta_1-\theta_2)}) = 0°,$$

was zu

$$\theta_1 = -90° + k \cdot 360° \qquad \forall\ k \in Z,$$

$$\theta_2 \approx +42{,}50573° + k \cdot 360° \qquad \forall\ k \in Z$$

und

$$\theta_3 \approx +47{,}49427° + k \cdot 360° \qquad \forall\ k \in Z$$

führt, wobei

$$\mathrm{arc}(S) := \angle\ S + k \cdot 360°\ [\mathrm{deg}]\ \forall\ k \in \odot$$

gilt, wobei

$$\angle S := \begin{cases} \arctan(\mathrm{Im}\{S\}/\mathrm{Re}\{S\}) & \text{für } \mathrm{Re}\{S\}>0 \text{ und } \mathrm{Im}\{S\}>0 \\ 360°+\arctan(\mathrm{Im}\{S\}/\mathrm{Re}\{S\}) & \text{für } \mathrm{Re}\{S\}>0 \text{ und } \mathrm{Im}\{S\}<0 \\ 180°+\arctan(\mathrm{Im}\{S\}/\mathrm{Re}\{S\}) & \text{für } \mathrm{Re}\{S\}<0 \\ 0° & \text{für } \mathrm{Re}\{S\}>0 \text{ und } \mathrm{Im}\{S\}=0 \\ 90° & \text{für } \mathrm{Re}\{S\}=0 \text{ und } \mathrm{Im}\{S\}>0 \\ 180° & \text{für } \mathrm{Re}\{S\}<0 \text{ und } \mathrm{Im}\{S\}=0 \\ 270° & \text{für } \mathrm{Re}\{S\}=0 \text{ und } \mathrm{Im}\{S\}<0 \end{cases}$$

das Argument eines Signals S komplexen Wertes bezeichnet, das gegeben ist in der Form $S = |S| \cdot e^{j.arc(S)}$ ($|S| \neq 0$).

**9.** Fünf Anschlüsse aufweisende Verbindungsvorrichtung nach einem der Ansprüche 1 bis 8, **dadurch gekennzeichnet, dass** zumindest eines der passiven N-Anschluss-Netzwerke (114 und 402a-c) mittels eines Widerstands-Netzwerks realisiert ist.

**10.** Fünf Anschlüsse aufweisende Verbindungsvorrichtung nach einem der Ansprüche 1 bis 9, **dadurch gekennzeichnet, dass** ein Gleichstromverstärker-Netzwerk (600) mit zumindest drei Anschlüssen (401c-e) der betreffenden fünf Anschlüsse aufweisende Verbindungsvorrichtung (102) verbunden ist, um die in Phase befindliche Komponente (I) und die um 90° phasenverschobene Komponente (Q) des empfangenen HF-Eingangssignals ($S_1$) zu erhalten.

**11.** Mobiler Funkempfänger, **gekennzeichnet, durch** eine fünf Anschlüsse aufweisende Verbindungsvorrichtung (102) nach einem der Ansprüche 1 bis 10, wobei diese Verbindungsvorrichtung speziell für eine direkte Abwärts-Umsetzung eines empfangenen modulierten HF-Eingangssignals ($S_1$) ausgelegt ist.

**12.** Mobiler Funkempfänger nach Anspruch 11, **dadurch gekennzeichnet, dass** die genannte fünf Anschlüsse aufweisende Verbindungsvorrichtung (102) Einrichtungen zur Durchführung einer direkten Abwärts-Umsetzung eines empfangenen n-PSK-, 2-QAM- oder OFDM-modulierten H-Eingangssignals ($S_1$) aufweist.

**13.** Verfahren zur Unterstützung einer direkten Abwärts-Umsetzung von empfangenen modulierten HF-Signalen, **dadurch gekennzeichnet, dass** ein mobiler Funkempfänger, der eine fünf Anschlüsse aufweisende Verbindungsvorrichtung (102) nach einem der Ansprüche 1 bis 10 für die Verarbeitung von modulierten HF-Signalen verwendet, angewandt wird,
umfassend die folgenden Schritte:

- Eingabe von zwei HF-Eingangssignalen ($S_1$ und $S_2$) an den betreffenden fünf Anschlüsse aufweisenden Empfänger,
- Abgabe von drei Ausgangssignalen, die auf linearen Kombinationen der betreffenden zwei HF-Eingangssignale ($S_1$ und $S_2$) basieren, und
- Ermittelung der Leistungspegel ($P_3$, $P_4$ und $P_5$) der betreffenden drei Ausgangssignale.

**14.** Verfahren nach Anspruch 13, **dadurch gekennzeichnet, dass** eine komplexe lineare Transformation zur Berechnung der korrekten Modulationszustandswerte eines ersten HF-Eingangssignals ($S_1$), welches durch das in Phase befindliche Signal (I) und das um 90° phasenverschobene Signale (Q) des betreffenden ersten HF-Eingangssignals ($S_1$) dargestellt ist, auf der Basis der tatsächlich ermittelten Leistungswerte ($P_3$, $P_4$ und $P_5$) angewandt wird, wobei die Koeffizienten der betreffenden komplexen linearen Transformation dadurch berechnet werden, dass zuvor festgelegte Modulationszustände eines als Kalibriersignal verwendeten zweiten HF-Eingangssignals ($S_2$) mit den tatsächlich ermittelten Leistungswerten ($P_3$, $P_4$ und $P_5$) verglichen werden.

**15.** Verfahren, das so ausgelegt ist, dass eine Kalibrierung der fünf Anschlüsse aufweisende Verbindungsvorrichtung (102) gemäß einem der Ansprüche 1 bis 10 erfolgt, **dadurch gekennzeichnet, dass** eine Trennung der HF-Eingangssignale ($S_1$ und $S_2$) mittels einer Phasenverschiebung zumindest eines der betreffenden HF-Eingangssigna-

le ($S_1$ und $S_2$) erzielt wird, derart, dass dadurch gewährleistet ist, dass nach erfolgter Vornahme der betreffenden Phasenverschiebungen die Phase des ersten HF-Eingangssignals ($S_1$) sich von der Phase des zweiten HF-Signals ($S_2$) unterscheidet.

**16.** Verfahren nach Anspruch 15, **dadurch gekennzeichnet, dass** drei Phasenverschiebungen unter Heranziehung der Phasenverschiebungswinkel ($\theta_1$, $\theta_2$ und $\theta_3$) von drei Phasenschiebern (112a-c) ausgeführt werden, wobei die betreffenden Phasenverschiebungswinkel der Gleichung

$$\theta_1 := 180° + \theta_2 + \theta_3 + k \cdot 360°$$

genügen, wobei k ein beliebiger ganzzahliger Wert ist, um HF-Eingangssignale ($S_1$ und $S_2$) mit entgegengesetzten Phasen zur Schaffung einer Trennung der genannten HF-Eingangssignale ($S_1$ und $S_2$) zu erzielen.

**17.** Verfahren nach Anspruch 16, **dadurch gekennzeichnet, dass** die Phasenverschiebungswinkel $\theta_1$ und $\theta_3$ den folgenden zwei Gleichungen genügen

$$\mathrm{arc}(4\text{-}e^{j \cdot 2 \cdot \theta_1})\text{-}\ \mathrm{arc}(5 \cdot e^{j \cdot \theta_1}) = 90°$$

und

$$\mathrm{arc}(e^{j(\theta_1+\theta_2)}\text{-}4 \cdot e^{j(\theta_1-\theta_2)}) - \mathrm{arc}(6 \cdot e^{j\theta_2} - e^{j(2 \cdot \theta_1-\theta_2)}) = 0°,$$

was zu

$$\theta_1 = -90° + k \cdot 360° \qquad \forall\ k \in Z,$$

$$\theta_2 \approx +42{,}50573° + k \cdot 360° \qquad \forall\ k \in Z$$

und

$$\theta_3 \approx +47{,}49427° + k \cdot 360° \qquad \forall\ k \in Z$$

führt, wobei

$$\mathrm{arc}(S) := \angle\ S + k \cdot 360°\ [\mathrm{deg}]\ \forall\ k \in \odot$$

gilt, wobei

$$\angle S := \begin{cases} \arctan(Im\{S\}/Re\{S\}) & \text{für } Re\{S\}>0 \text{ und } Im\{S\}>0 \\ 360°+\arctan(Im\{S\}/Re\{S\}) & \text{für } Re\{S\}>0 \text{ und } Im\{S\}<0 \\ 180°+\arctan(Im\{S\}/Re\{S\}) & \text{für } Re\{S\}<0 \\ 0° & \text{für } Re\{S\}>0 \text{ und } Im\{S\}=0 \\ 90° & \text{für } Re\{S\}=0 \text{ und } Im\{S\}>0 \\ 180° & \text{für } Re\{S\}<0 \text{ und } Im\{S\}=0 \\ 270° & \text{für } Re\{S\}=0 \text{ und } Im\{S\}<0 \end{cases}$$

das Argument eines Signals S komplexen Wertes bezeichnet, das gegeben ist in der Form $S = |S| \cdot e^{j \cdot arc(S)}$ ($|S| \neq 0$).

**18.** Verfahren nach einem der Ansprüche 14 bis 17, **dadurch gekennzeichnet, dass** das in Phase befindliche Signal (I) und das um 90° phasenverschobene Signal (Q) durch eine lineare Kombination von zwei unterschiedlichen Paaren von Leistungspegeln (($P_3$, $P_5$) und ($P_3$, $P_4$)) berechnet werden, die an den drei Ausgangsanschlüssen (401c-e) der vorgeschlagenen fünf Anschlüsse aufweisenden Verbindungsvorrichtung (102) ermittelt werden.

**19.** Verfahren nach Anspruch 18, **dadurch gekennzeichnet, dass** das in Phase befindliche Signal (I) als Funktion ($f_1$) der Leistungspegel ($P_3$ und $P_5$) berechnet wird, die an den Ausgangsanschlüssen (104c+e) des ersten passiven N-Anschluss-Netzwerks (114) bzw. des zweiten passiven, drei Anschlüsse aufweisenden Netzwerks (402c) ermittelt werden, und dass das um 90° phasenverschobene Signal (Q) als Funktion ($f_2$) der Leistungspegel ($P_3$ und $P_4$) berechnet wird, die an den Ausgangsanschlüssen (104c+d) des ersten passiven N-Anschluss-Netzwerks (114) bzw. des ersten passiven, drei Anschlüsse aufweisenden Netzwerks (402a) ermittelt werden, entsprechend den folgenden Gleichungen:

$$I = f_1(P_3,P_5) = g_5 \cdot (P_5 - g_1 \cdot P_3 - g_3 \cdot P_0)$$

und

$$Q = f_2(P_3,P_4) = g_6 \cdot (-P_4 + g_2 \cdot P_3 + g_4 \cdot P_0),$$

wobei $g_1, g_2, \ldots g_6 \in \mathbf{R}$ und

$$P_0 := |S_2|^2 = 50mW \cdot 10^{\frac{P_{LO}[dBm]}{10}}$$

gilt,
wobei $P_0$ [mW] den Leistungspegel des durch den örtlichen Oszillator (LO) erzeugen HF-Signals ($S_2$) bedeutet und wobei $g_1 \ldots g_6$ die Verstärkungsfaktoren der Gleichstromverstärker (602a-f) sind, welche in dem Gleichstromverstärker-Netzwerk (600) verwendet sind, das mit den drei Ausgangsanschlüssen (401c-e) der fünf Anschlüsse aufweisenden Verbindungsvorrichtung (102) verbunden ist, wobei die betreffenden Verstärkungsfaktoren aus den komplexwertigen Übertragungskoeffizienten ($k_{mn}$) der fünf Anschlüsse aufweisenden Verbindungsvorrichtung (102) abgeleitet sind (wobei die Indices m, n ∈ {1, 2,...,5}) gelten), und wobei die Übertragungskoeffizienten ($k_{mn}$) den Anteil eines vom Anschluss #n her kommenden HF-Signals repräsentieren, der am Anschluss #m gemessen wird.

**20.** Mobile Telekommunikationsvorrichtung, bei der ein mobiler Funkempfänger nach Anspruch 11 oder 12 angewandt ist.

**21.** Mobile Telekommunikationsvorrichtung,
**gekennzeichnet durch** Einrichtungen, die so angeordnet bzw. ausgelegt sind, dass ein Verfahren nach Anspruch 13 oder 14 ausgeführt wird.

**22.** Mobile Telekommunikationsvorrichtung, umfassend einen mobilen Funkempfänger unter Verwendung einer fünf Anschlüsse aufweisenden Verbindungsvorrichtung (102) nach einem der Ansprüche 1 bis 10, **gekennzeichnet durch** Einrichtungen, die so angeordnet bzw. ausgelegt sind, dass ein Verfahren nach einem der Ansprüche 15 bis 19 ausgeführt wird.

**Revendications**

**1.** Dispositif de jonction à cinq ports qui est utilisé pour traiter des signaux RF modulés qui sont reçus par un récepteur radio mobile, dans lequel ledit dispositif de jonction à cinq ports (102) comprend :

au moins deux ports d'entrée RF (401 a+b) pour deux signaux d'entrée RF ($S_1$ et $S_2$) ;

au moins trois ports de sortie (401 c-e) pour émettre en sortie des signaux représentant trois niveaux de puissance détectés ($P_3$, $P_4$ et $P_5$) ;

un premier (114) et un second (402b) réseaux à N ports passifs connectés l'un à l'autre au moyen d'un circuit non réciproque (112), dans lequel chacun desdits réseaux à N ports passifs (114 et 402b) est connecté à l'un différent desdits ports d'entrée RF (401a+b) et ledit premier réseau à N ports passifs (114) comprend un port de sortie (401c) pour un signal représentant un premier niveau de puissance de sortie ($P_3$) ; et

au moins trois détecteurs de puissance (104a-c) pour détecter les niveaux de puissance respectifs ($P_3$, $P_4$ et $P_5$) desdits signaux de sortie,

dans lequel :

ledit circuit non réciproque (112) comprend deux branches, la première branche contenant au moins un décaleur de phase (112a) de même qu'un premier réseau à trois ports passifs (402a) qui comporte un port de sortie (401d) pour un signal représentant un second niveau de puissance de sortie ($P_4$) et la seconde branche contenant au moins deux décaleurs de phase (112b+c) de même qu'un second réseau à trois ports passifs (402c) comportant un port de sortie (401e) pour un signal représentant un troisième niveau de puissance de sortie ($P_5$),

la première extrémité de chaque branche particulière est connectée au premier réseau à N ports passifs (114) et la seconde extrémité de chaque branche est connectée au second réseau à N ports passifs (402b) pour assurer une isolation passive des deux signaux d'entrée RF ($S_1$ et $S_2$),

**caractérisé en ce que** :

chacun desdits réseaux à trois ports (402a+c) est connecté au second réseau à N ports passifs (402b) par au moins un décaleur de phase (112a ou 112b, de façon respective).

**2.** Dispositif de jonction à cinq ports selon la revendication 1, **caractérisé en ce que** le premier réseau à N ports passifs (114) est réalisé en tant que réseau à quatre ports passifs.

**3.** Dispositif de jonction à cinq ports selon l'une quelconque des revendications 1 et 2, **caractérisé en ce que** le second réseau à N ports passifs (402b) est réalisé en tant que réseau à trois ports passifs.

**4.** Dispositif de jonction à cinq ports selon l'une quelconque des revendications 1 à 3, **caractérisé en ce que** le premier réseau à N ports passifs (114) comprend un port d'entrée (401a) pour l'entrée d'un premier signal d'entrée RF ($S_1$).

**5.** Dispositif de jonction à cinq ports selon l'une quelconque des revendications 1 à 4, **caractérisé en ce que** le second réseau à N ports passifs (402b) comprend un port d'entrée (401 b) pour l'entrée d'un second signal d'entrée RF ($S_2$).

**6.** Dispositif de jonction à cinq ports selon l'une quelconque des revendications 1 à 5, **caractérisé en ce que** l'un des ports d'entrée RF (401b) reçoit en application un signal d'entrée RF ($S_2$) qui prend son origine depuis un oscillateur local.

**7.** Dispositif de jonction à cinq ports selon l'une quelconque des revendications 1 à 6, **caractérisé en ce que** les

angles de décalage de phase ($\theta_1$, $\theta_2$ et $\theta_3$) de trois décaleurs de phase (112a-c) satisfont l'équation :

$$\theta_1 := 180° + \theta_2 + \theta_3 + k \cdot 360°,$$

où k est une valeur entière arbitraire,
afin d'obtenir des signaux d'entrée RF ($S_1$ et $S_2$) présentant des phases opposées pour assurer une isolation desdits signaux d'entrée RF ($S_1$ et $S_2$).

**8.** Dispositif de jonction à cinq ports selon la revendication 7, **caractérisé en ce que** les angles de décalage de phase $\theta_1$ et $\theta_3$ satisfont les deux équations qui suivent :

$$\mathrm{arc}(4 - e^{j.2.\theta_1}) - \mathrm{arc}(5 . e^{j \cdot \theta_1}) = 90°$$

et

$$\mathrm{arc}(e^{j.(\theta_1+\theta_2)} - 4 \cdot e^{j \cdot (\theta_1-\theta_2)}) - \mathrm{arc}(6 \cdot e^{j \cdot \theta_2} - e^{j \cdot (2 \cdot \theta_1-\theta_2)}) = 0°,$$

ce qui conduit à :

$$\theta_1 = -90° + k \cdot 360° \qquad \forall\, k \in Z,$$

$$\theta_2 \approx +42{,}50573° + k \cdot 360° \qquad \forall\, k \in Z,$$

et

$$\theta_3 \approx +47{,}49427° + k \cdot 360° \qquad \forall\, k \in Z,$$

où :

$$\mathrm{arc}(S) := \angle S + k \cdot 360°\ [\mathrm{deg}]\ \forall\, k \in \odot$$

avec :

$$\angle S := \begin{cases} \arctan(\mathrm{Im}\{S\}/\mathrm{Re}\{S\}) & \text{pour } \mathrm{Re}\{S\} > 0 \text{ et } \mathrm{Im}\{S\} > 0 \\ 360° + \arctan(\mathrm{Im}\{S\}/\mathrm{Re}\{S\}) & \text{pour } \mathrm{Re}\{S\} > 0 \text{ et } \mathrm{Im}\{S\} < 0 \\ 180° + \arctan(\mathrm{Im}\{S\}/\mathrm{Re}\{S\}) & \text{pour } \mathrm{Re}\{S\} < 0 \\ 0° & \text{pour } \mathrm{Re}\{S\} > 0 \text{ et } \mathrm{Im}\{S\} = 0 \\ 90° & \text{pour } \mathrm{Re}\{S\} = 0 \text{ et } \mathrm{Im}\{S\} > 0 \\ 180° & \text{pour } \mathrm{Re}\{S\} < 0 \text{ et } \mathrm{Im}\{S\} = 0 \\ 270° & \text{pour } \mathrm{Re}\{S\} = 0 \text{ et } \mathrm{Im}\{S\} < 0 \end{cases}$$

qui représente l'argument d'un signal à valeur complexe S qui est donné sous la forme $S = |S| \cdot e^{j \cdot \mathrm{arc}(S)}$ ($|S| \neq 0$).

**9.** Dispositif de jonction à cinq ports selon l'une quelconque des revendications 1 à 8, **caractérisé en ce qu'**au moins l'un des réseaux à N ports passifs (114 et 402a-c) est réalisé au moyen d'un réseau résistif.

**10.** Dispositif de jonction à cinq ports selon l'une quelconque des revendications 1 à 9, **caractérisé par** un réseau d'amplificateurs DC (600) qui est connecté à au moins trois ports (401c-e) dudit dispositif de jonction à cinq ports (102) pour obtenir les composantes en phase (I) et en quadrature (Q) du signal d'entrée RF reçu ($S_1$).

**11.** Récepteur radio mobile **caractérisé par** un dispositif de jonction à cinq ports (102) selon l'une quelconque des revendications 1 à 10 qui est conçu spécialement pour une conversion abaisseuse directe d'un signal d'entrée RF modulé reçu ($S_1$).

**12.** Récepteur radio mobile selon la revendication 11, **caractérisé en ce que** ledit dispositif de jonction à cinq ports (102) comprend un moyen pour réaliser une conversion abaisseuse directe d'un signal d'entrée RF modulé n-PSK-, 2-QAM- ou OFDM reçu ($S_1$).

**13.** Procédé pour supporter une conversion abaisseuse directe de signaux RF modulés reçus, **caractérisé en ce que** :

un récepteur radio mobile comprenant un dispositif de jonction à cinq ports (102) utilisé pour le traitement de signaux RF modulés selon l'une quelconque des revendications 1 à 10 est appliqué, comprenant les étapes qui suivent :

entrée de deux signaux d'entrée RF ($S_1$ et $S_2$) sur ledit récepteur à cinq ports ;
sortie de trois signaux de sortie qui sont basés sur des combinaisons linéaires desdits deux signaux d'entrée RF ($S_1$ et $S_2$) ; et
détection des niveaux de puissance ($P_3$, $P_4$ et $P_5$) desdits trois signaux de sortie.

**14.** Procédé selon la revendication 13, **caractérisé en ce qu'**une transformation linéaire complexe est appliquée pour calculer les valeurs d'état de modulation correctes d'un premier signal d'entrée RF ($S_1$) qui est représenté par le signal en phase (I) et par le signal en quadrature (Q) dudit premier signal d'entrée RF ($S_1$) sur la base de valeurs de puissance détectées réellement ($P_3$, $P_4$ et $P_5$), dans lequel les coefficients de ladite transformation linéaire complexe sont calculés en comparant des états de modulation prédéfinis d'un second signal d'entrée RF ($S_2$) qui est utilisé en tant que signal d'étalonnage avec les valeurs de puissance détectées réellement ($P_3$, $P_4$ et $P_5$).

**15.** Procédé agencé pour assurer un étalonnage du dispositif de jonction à cinq ports (102) selon l'une quelconque des revendications 1 à 10, **caractérisé en ce qu'**une isolation des signaux d'entrée RF ($S_1$ et $S_2$) est réalisée au moyen d'un décalage de phase d'au moins l'un desdits signaux d'entrée RF ($S_1$ et $S_2$), ce qui assure qu'après réalisation desdits décalages de phase, la phase du premier signal d'entrée RF ($S_1$) diffère de la phase du second signal RF ($S_2$).

**16.** Procédé selon la revendication 15, **caractérisé en ce que** trois décalages de phase sont réalisés en utilisant les angles de décalage de phase ($\theta_1$, $\theta_2$ et $\theta_3$) de trois décaleurs de phase (112a-c) satisfaisant l'équation :

$$\theta_1 := 180° + \theta_2 + \theta_3 + k \cdot 360°,$$

où k est une valeur entière arbitraire,
afin d'obtenir des signaux d'entrée RF ($S_1$ et $S_2$) avec des phases opposées pour assurer une isolation desdits signaux d'entrée RF ($S_1$ et $S_2$).

**17.** Procédé selon la revendication 16, **caractérisé en ce que** les angles de décalage de phase $\theta_1$ et $\theta_{3*}$ satisfont les deux équations qui suivent :

$$\mathrm{arc}(4 - e^{j.2.\theta_1}) - \mathrm{arc}(5 \,.\, e^{j\cdot\theta_1}) = 90°$$

et

$$\mathrm{arc}(e^{j.(\theta_1+\theta_2)} - 4\cdot e^{j\cdot(\theta_1-\theta_2)}) - \mathrm{arc}(6\cdot e^{j\cdot\theta_2} - e^{j\cdot(2\cdot\theta_1-\theta_2)}) = 0°,$$

ce qui conduit à :

$$\theta_1 = -90° + k \cdot 360° \qquad \forall\ k \in Z,$$

$$\theta_2 \approx +42{,}50573° + k \cdot 360° \qquad \forall\ k \in Z,$$

et

$$\theta_3 \approx +47{,}49427° + k \cdot 360° \qquad \forall\ k \in Z,$$

où :

$$arc(S) := \angle S + k \cdot 360°\ [deg]\ \forall\ k \in \odot$$

avec :

$$\angle S := \begin{cases} \arctan(Im\{S\} / Re\{S\}) & \text{pour } Re\{S\} > 0 \text{ et } Im\{S\} > 0 \\ 360° + \arctan(Im\{S\} / Re\{S\}) & \text{pour } Re\{S\} > 0 \text{ et } Im\{S\} < 0 \\ 180° + \arctan(Im\{S\} / Re\{S\}) & \text{pour } Re\{S\} < 0 \\ 0° & \text{pour } Re\{S\} > 0 \text{ et } Im\{S\} = 0 \\ 90° & \text{pour } Re\{S\} = 0 \text{ et } Im\{S\} > 0 \\ 180° & \text{pour } Re\{S\} < 0 \text{ et } Im\{S\} = 0 \\ 270° & \text{pour } Re\{S\} = 0 \text{ et } Im\{S\} < 0 \end{cases}$$

qui représente l'argument d'un signal à valeur complexe S qui est donné sous la forme $S = |S| \cdot e^{j \cdot arc(S)}$ ($|S| \neq 0$).

**18.** Procédé selon l'une quelconque des revendications 14 à 17, **caractérisé en ce que** lesdits signaux en phase (I) et en quadrature (Q) sont calculés au moyen d'une combinaison linéaire de deux paires différentes de niveaux de puissance (($P_3$, $P_5$) et ($P_3$, $P_4$)) qui sont détectés au niveau des trois ports (401 c-e) du dispositif de jonction à cinq ports proposé (102).

**19.** Procédé selon la revendication 18, **caractérisé en ce que** le signal en phase (I) est calculé en tant que fonction ($f_1$) des niveaux de puissance ($P_3$ et $P_5$) qui sont détectés au niveau des ports de sortie (104c+e) du premier réseau à N ports passifs (114) et du second réseau à trois ports passifs (402c), de façon respective, et le signal en quadrature (Q) est calculé en tant que fonction ($f_2$) des niveaux de puissance ($P_3$ et $P_4$) qui sont détectés au niveau des ports de sortie (104c+d) du premier réseau à N ports passifs (114) et du second réseau à trois ports passifs (402a), de façon respective, conformément aux équations qui suivent :

$$I = f_1(P_3, P_5) = g_5 \cdot (P_5 - g_1 \cdot P_3 - g_3 \cdot P_0)$$

et

$$Q = f_2(P_3, P_4) = g_6 \cdot (-P_4 + g_2 \cdot P_3 + g_4 \cdot P_0)$$

avec $g_1, g_2, ..., g_6 \in \mathbf{R}$ et

$$P_0 := |S_2|^2 = 50\ mW \cdot 10^{\frac{P_{LO}[dBm]}{10}}$$

où :

$P_0$ [mW] représente le niveau de puissance du signal RF ($S_2$) qui est généré par l'oscillateur local (LO) ; et $g_1$, ..., $g_6$ sont les facteurs de gain des amplificateurs DC (602a-f) qui sont utilisés dans le réseau d'amplificateurs DC (600) qui est connecté aux trois ports de sortie (401 c-e) du dispositif de jonction à cinq ports (102), lesquels facteurs de gain sont dérivés à partir des coefficients de transfert à valeur complexe ($k_{mn}$) du dispositif de jonction à cinq ports (102) (avec les indices m, n $\in$ {1, 2, ..., 5}), lesdits coefficients de transfert ($k_{mn}$) représentant la partie d'un signal RF provenant d'un port #n qui est mesurée au niveau d'un port #m.

**20.** Dispositif de télécommunication mobile, dans lequel un récepteur radio mobile selon l'une quelconque des revendications 11 ou 12 est appliqué.

**21.** Dispositif de télécommunication mobile **caractérisé par** un moyen qui est agencé pour réaliser un procédé selon l'une quelconque des revendications 13 ou 14.

**22.** Dispositif de télécommunication mobile comprenant un récepteur radio mobile qui utilise un dispositif de jonction à cinq ports (102) selon l'une quelconque des revendications 1 à 10, **caractérisé par** un moyen agencé pour réaliser un procédé selon l'une quelconque des revendications 15 à 19.

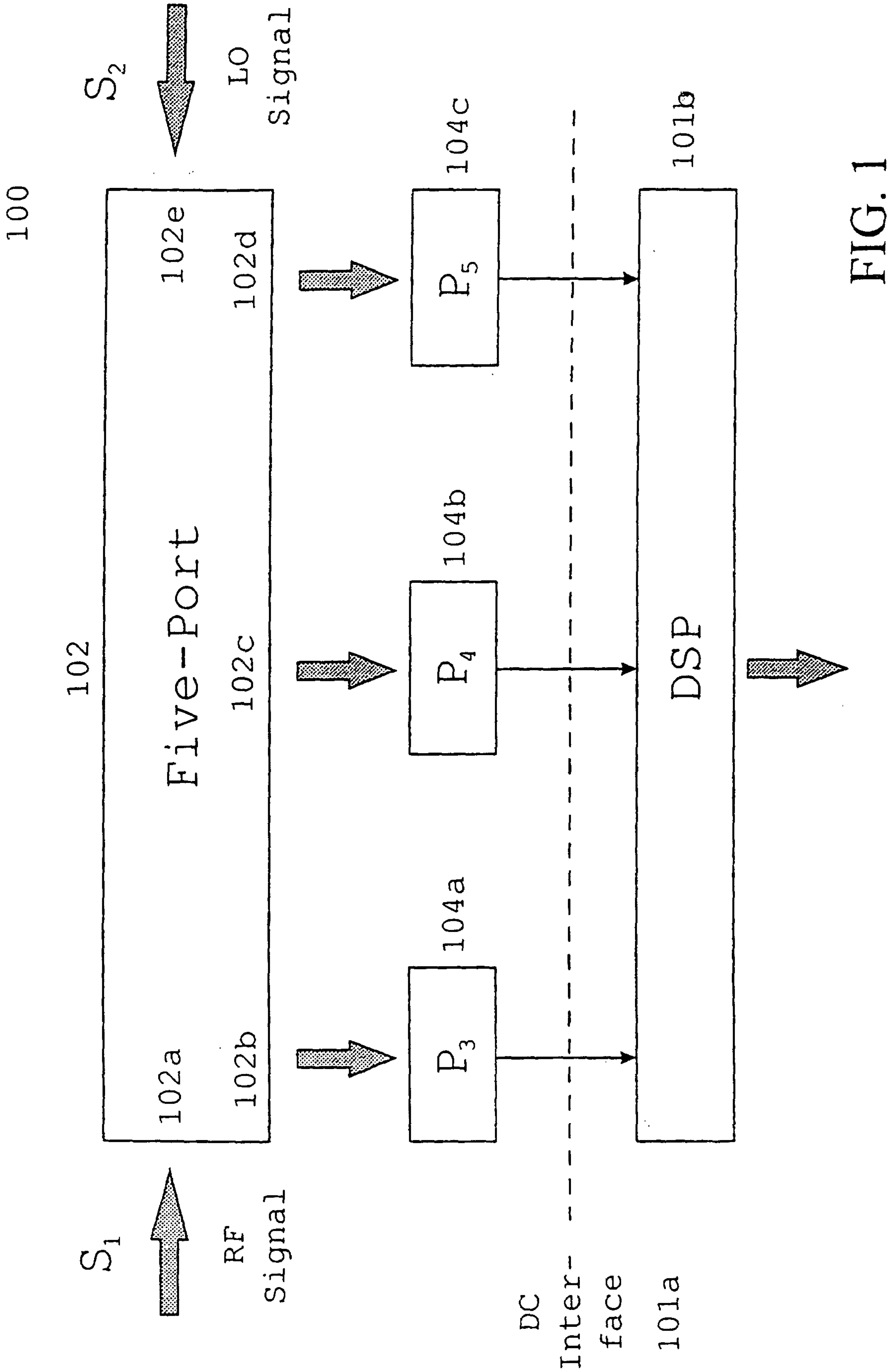
100
$S_2$
LO Signal
102
Five-Port
102e
102d
102c
102a
102b
$S_1$
RF Signal
104a
104b
104c
$P_3$
$P_4$
$P_5$
DC Inter-face
101a
101b
DSP

FIG. 1

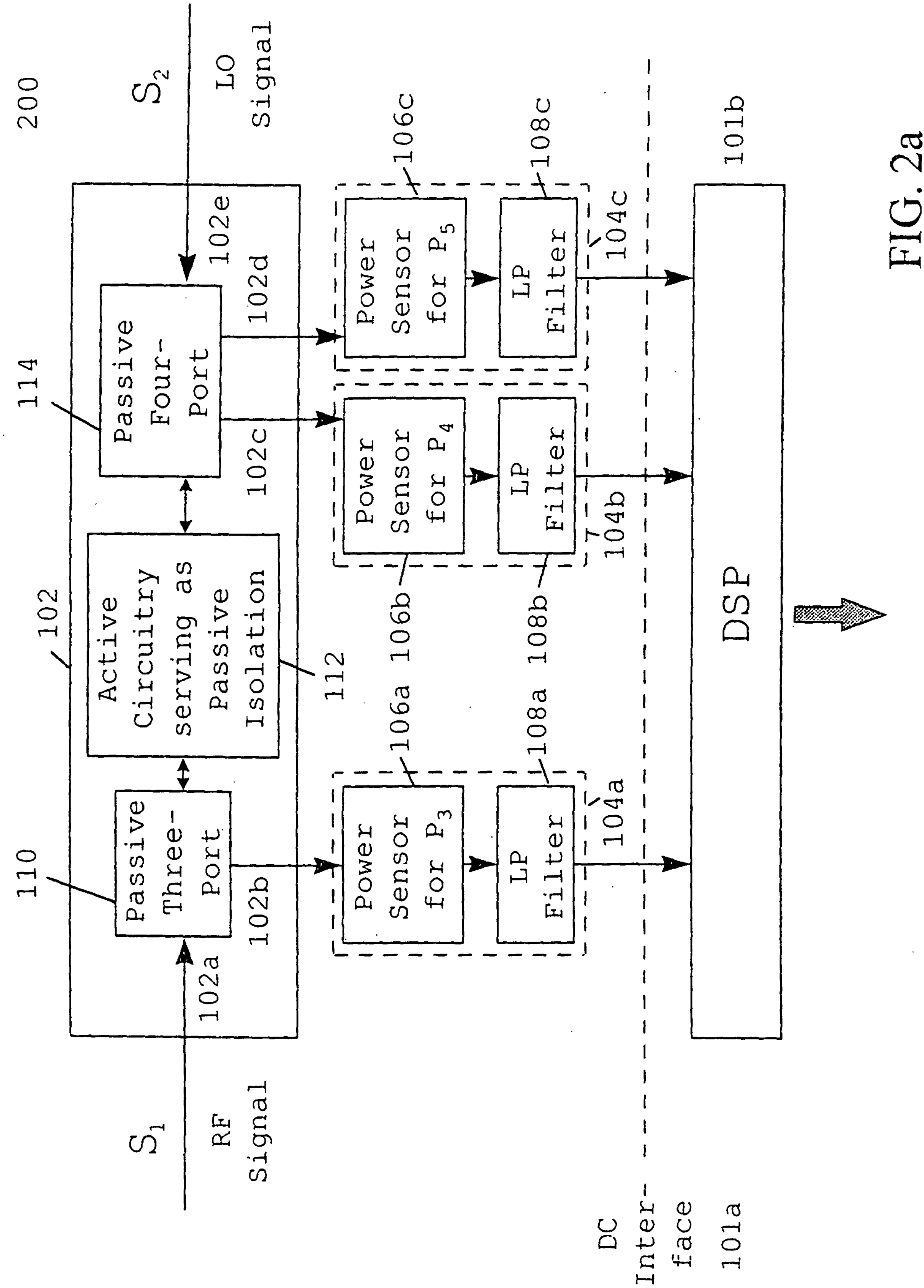
200
$S_2$
LO Signal
102
114
Passive Four-Port
102e
102d
102c
Active Circuitry serving as Passive Isolation
112
110
Passive Three-Port
102a
102b
$S_1$
RF Signal
106c
Power Sensor for $P_5$
108c
LP Filter
104c
106a 106b
Power Sensor for $P_4$
108a 108b
LP Filter
104b
Power Sensor for $P_3$
LP Filter
104a
DC Interface 101a
101b
DSP

FIG. 2a

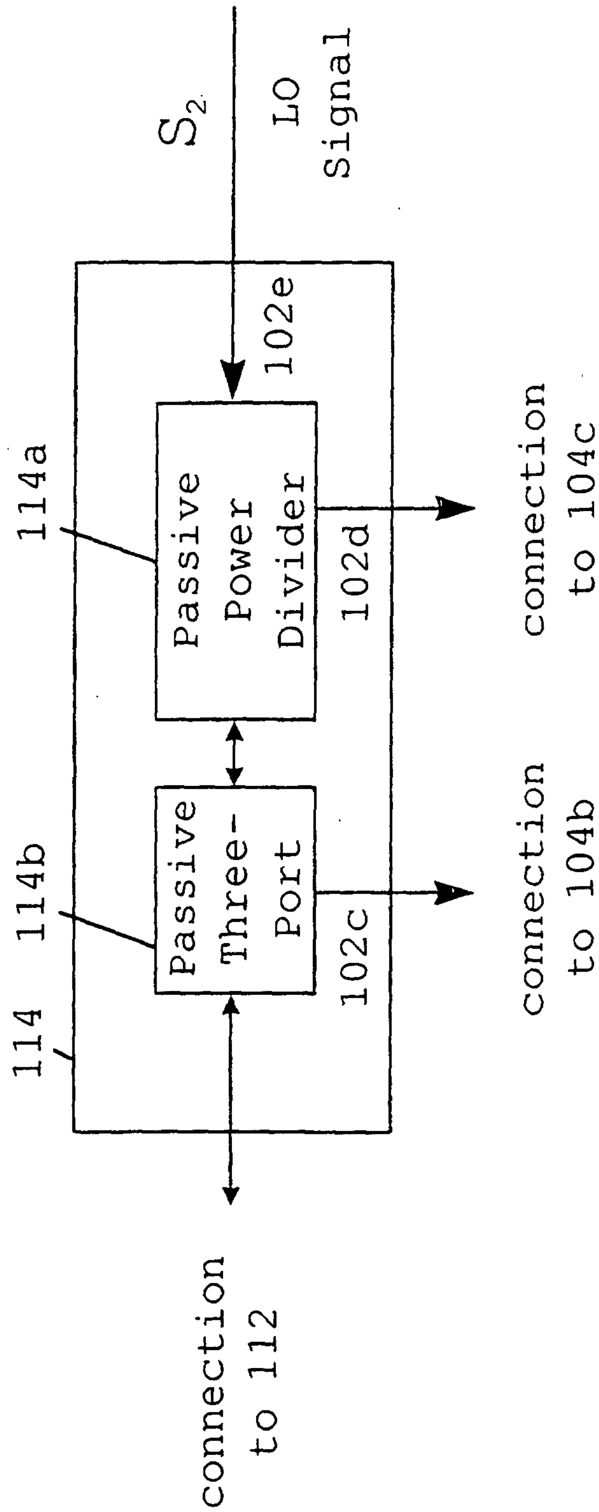
S2
LO Signal
102e
114a
Passive Power Divider
102d
connection to 104c
114
114b
Passive Three-Port
102c
connection to 104b
connection to 112

FIG. 2b

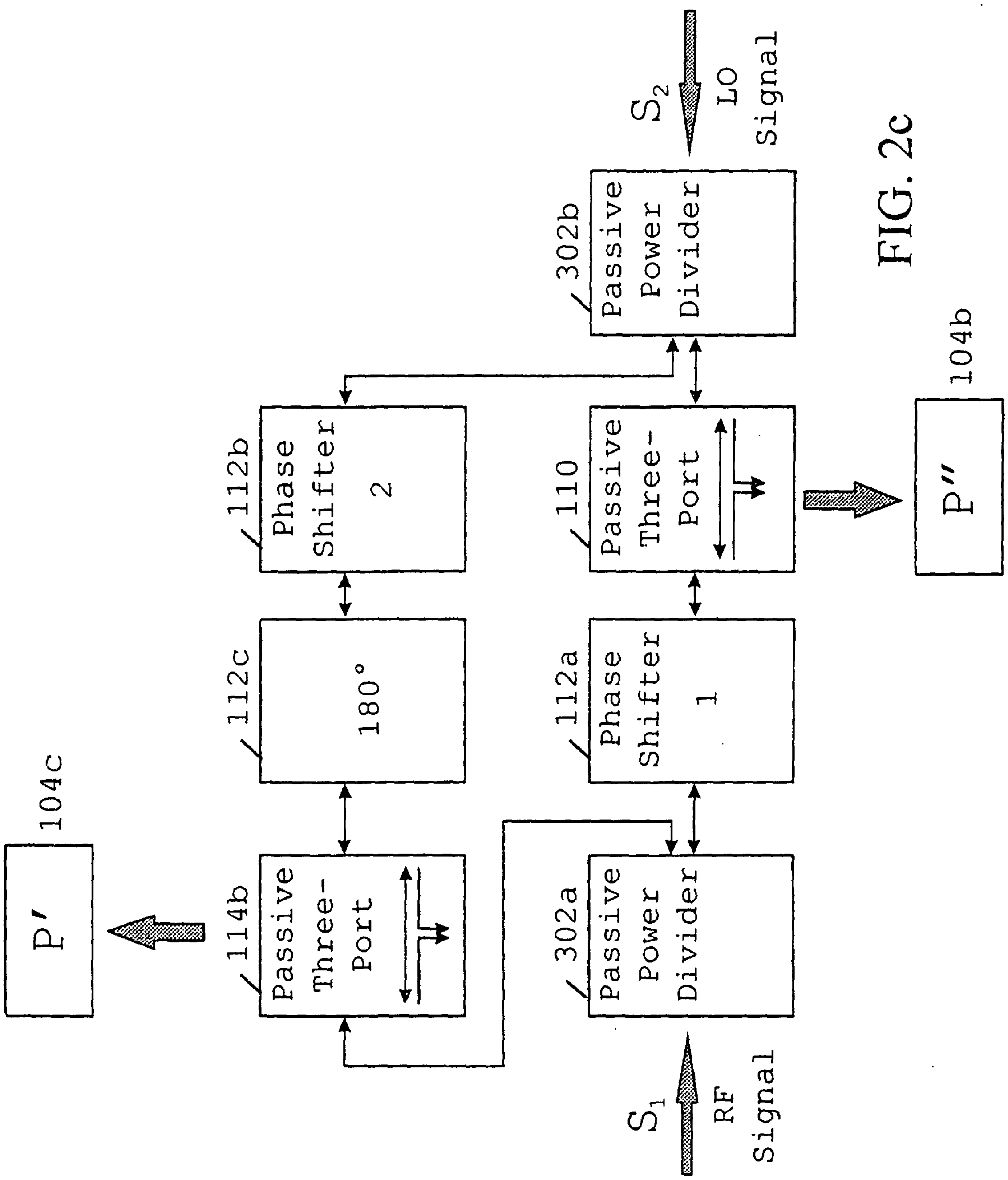
S2
LO Signal
302b
Passive Power Divider
112b
Phase Shifter 2
110
Passive Three-Port
104b
P″
112c
180°
112a
Phase Shifter 1
104c
P′
114b
Passive Three-Port
302a
Passive Power Divider
S1
RF Signal

FIG. 2c

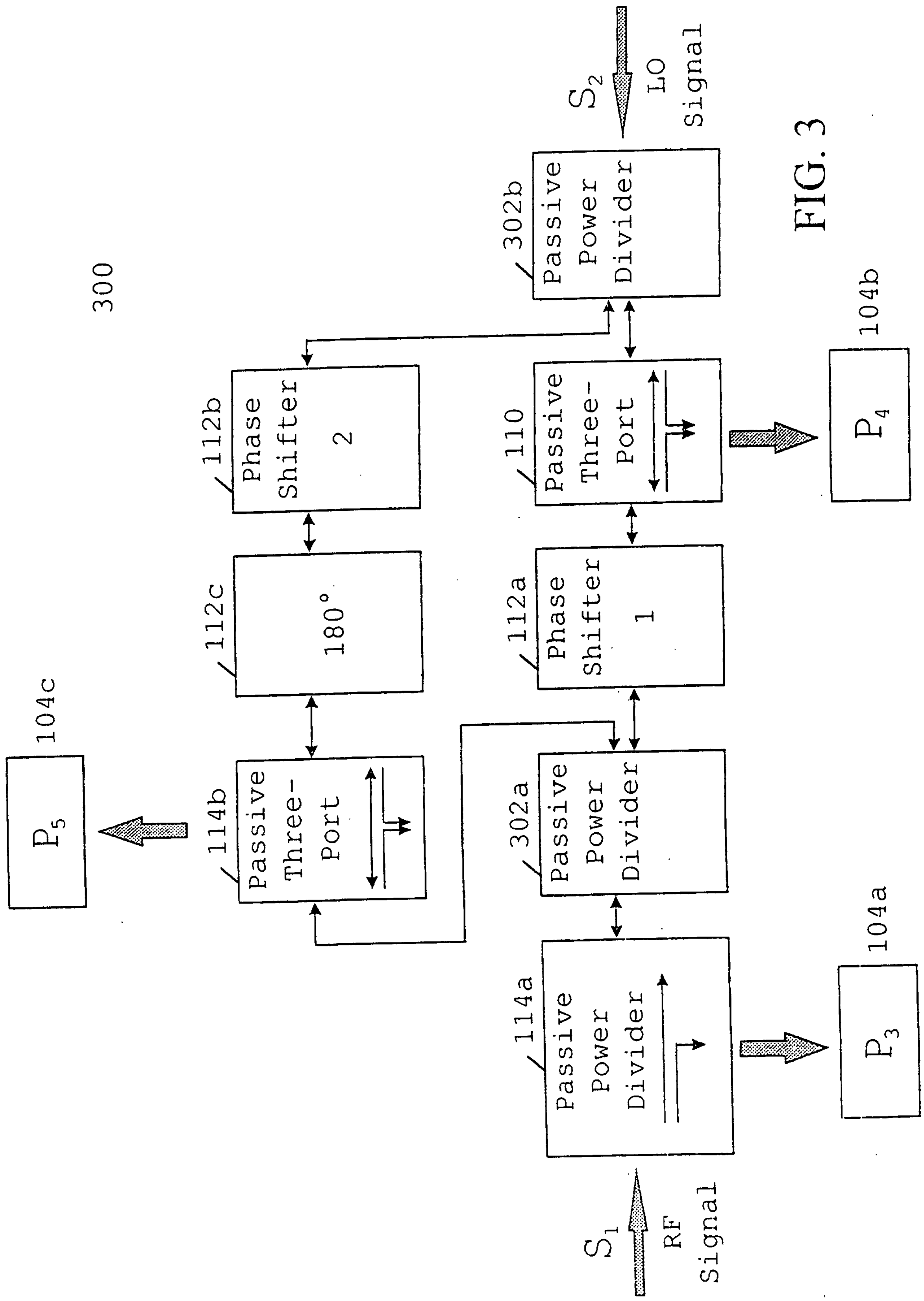
300
S2
LO Signal
302b
Passive Power Divider
112b
Phase Shifter 2
110
Passive Three-Port
104b
P4
112c
180°
112a
Phase Shifter 1
104c
P5
114b
Passive Three-Port
302a
Passive Power Divider
114a
Passive Power Divider
104a
P3
S1
RF Signal

FIG. 3

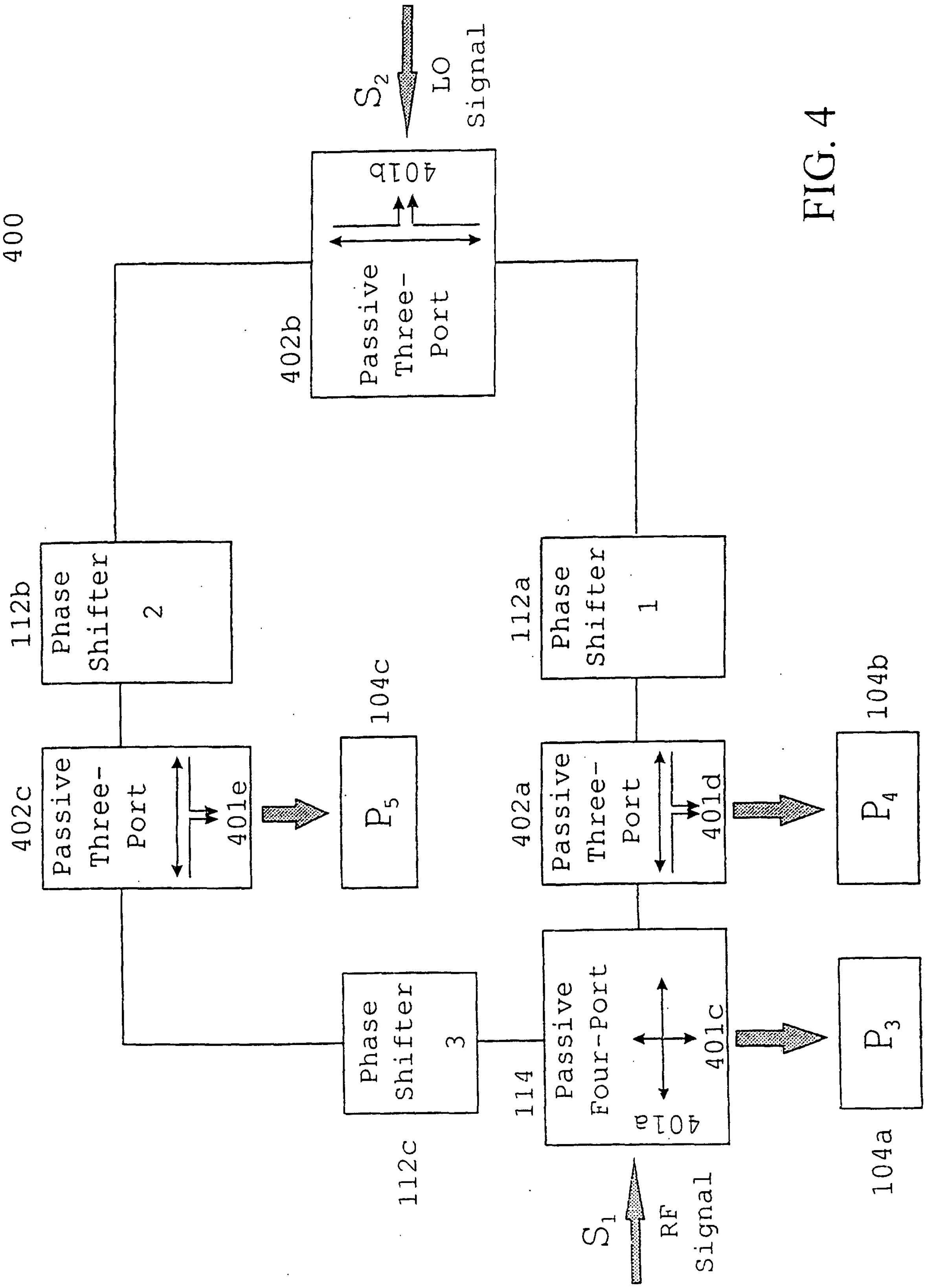
400
S2
LO Signal
401b
Passive Three-Port
402b
Phase Shifter 2
112b
Phase Shifter 1
112a
104c
104b
Passive Three-Port
402c
401e
P5
Passive Three-Port
402a
401d
P4
Phase Shifter 3
112c
Passive Four-Port
114
401c
401a
P3
104a
S1
RF Signal

FIG. 4

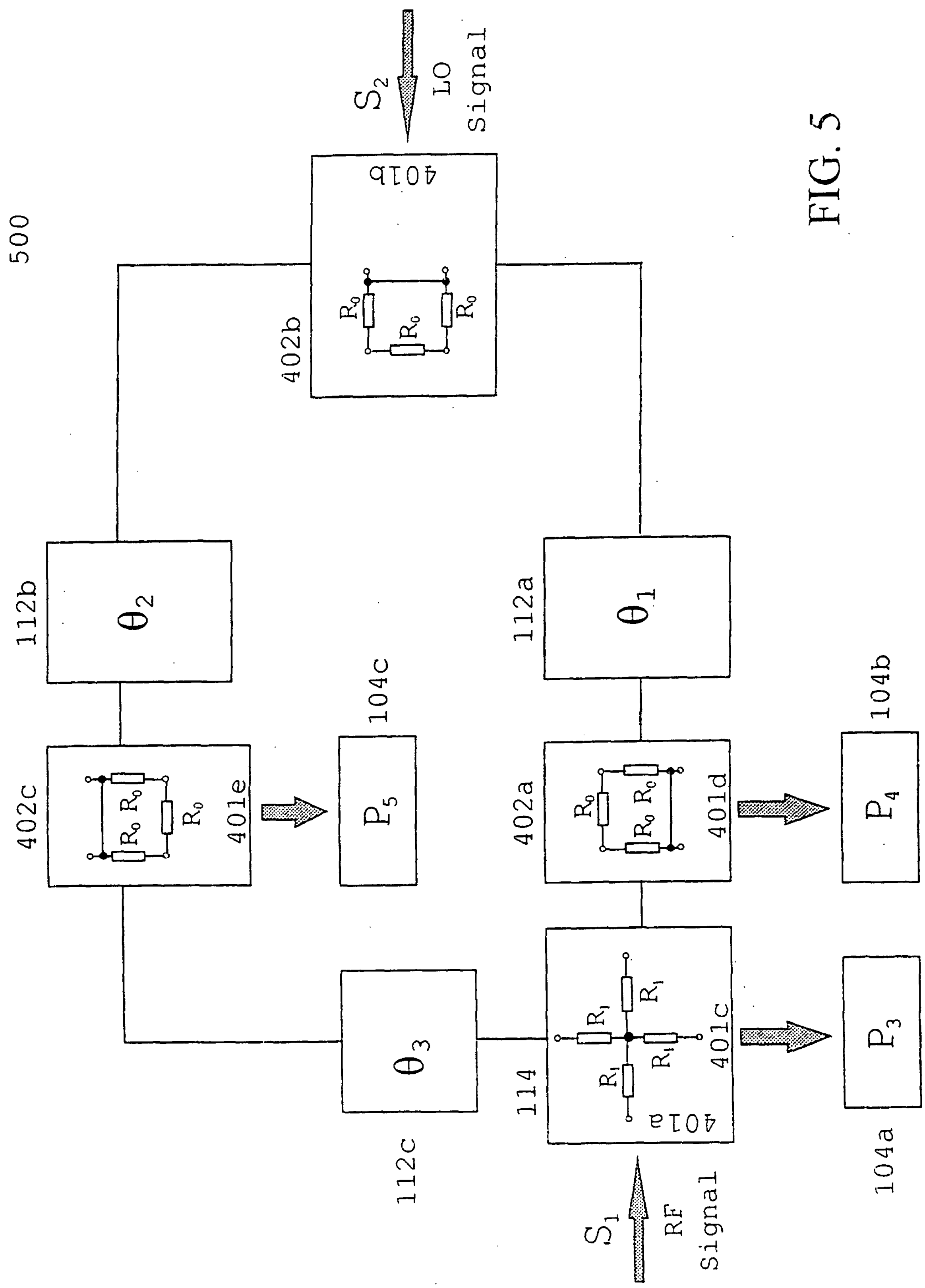
500
$S_2$
LO
Signal
401b
402b
$R_0$
$R_0$
$R_0$
112b
$\theta_2$
112a
$\theta_1$
104c
$P_5$
402c
$R_0$ $R_0$
$R_0$
401e
402a
$R_0$
$R_0$ $R_0$
401d
104b
$P_4$
112c
$\theta_3$
114
$R_1$
$R_1$
$R_1$
$R_1$
401a
401c
$P_3$
104a
$S_1$
RF
Signal

FIG. 5

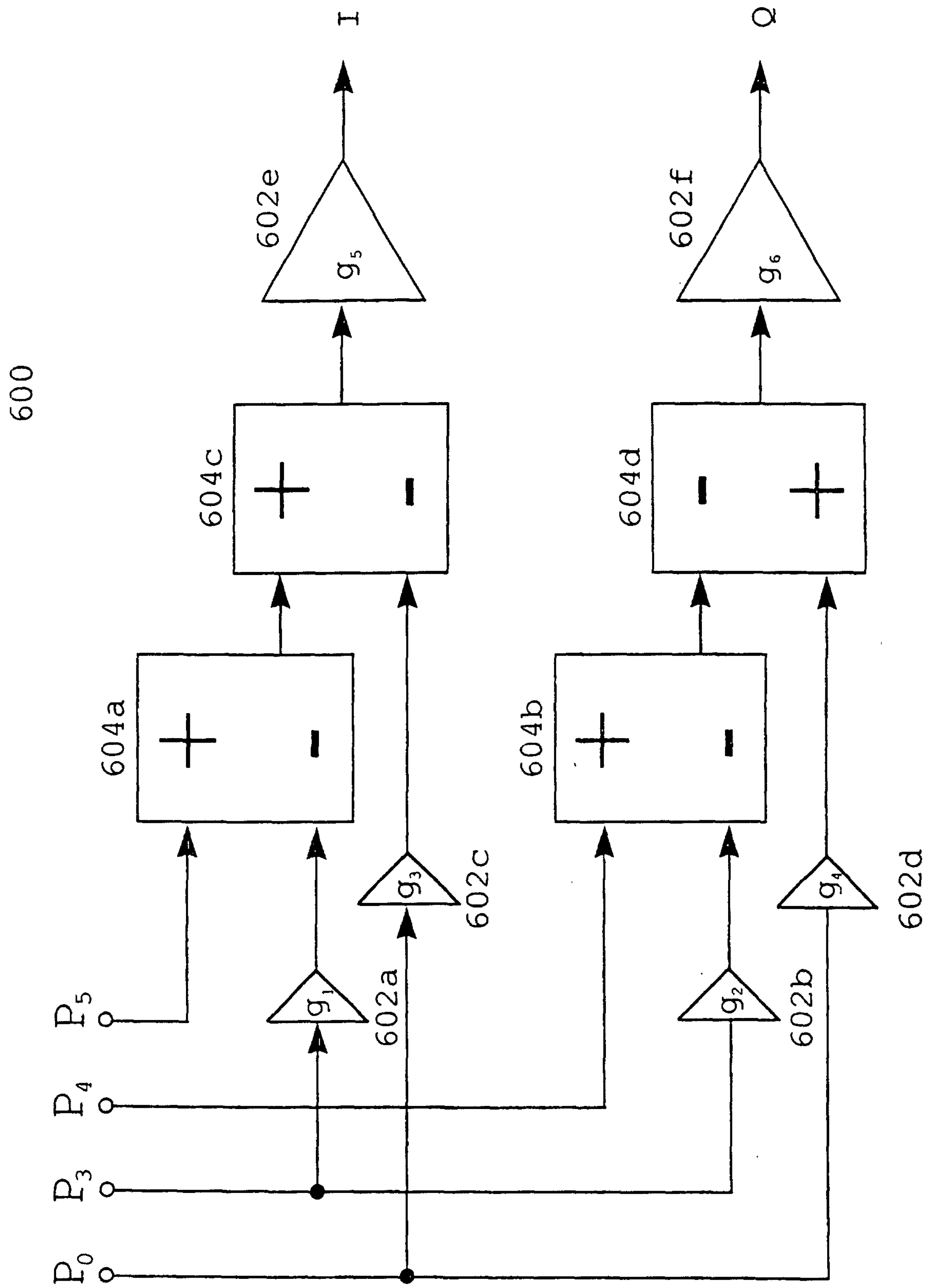
600
$P_5$
$P_4$
$P_3$
$P_0$
$g_1$
602a
$g_2$
602b
$g_3$
602c
$g_4$
602d
604a
604b
604c
604d
$g_5$
602e
$g_6$
602f
I
Q

FIG. 6

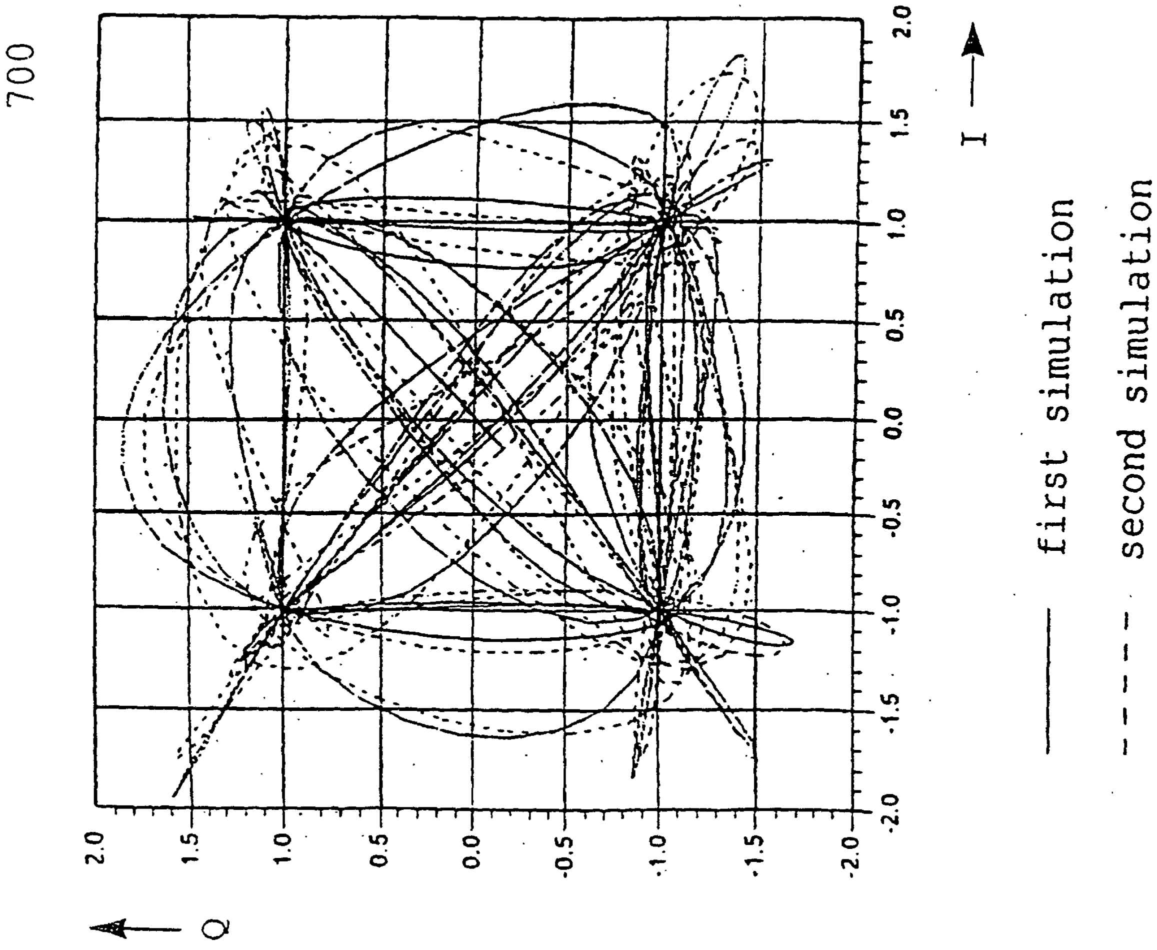
700
Q
I
2.0
1.5
1.0
0.5
0.0
-0.5
-1.0
-1.5
-2.0
first simulation
second simulation

FIG. 7